# EUROPEAN PATENT APPLICATION

(11) **EP 2 743 969 A1**
(43) Date of publication of application: **18.06.2014**
(21) Application number: 12823923.3
(22) Date of filing: 10.08.2012
(51) Int. Cl.: H01L 21/308, H01L 31/04

(54) **ETCHING METHOD AND METHOD FOR PERFORMING SURFACE PROCESSING ON SOLID MATERIAL FOR SOLAR CELL**

(30) Priority: 12.08.2011 JP 2011177338; 01.12.2011 JP 2011264131
(71) Applicant: Osaka University, Suita-shi, Osaka 565-0871 (JP); Daikin Industries, Ltd., Osaka 530-8323 (JP)
(72) Inventor: MORITA, Mizuho, Suita-shi Osaka 565-0871 (JP); UCHIKOSHI, Junichi, Suita-shi Osaka 565-0871 (JP); TSUKAMOTO, Kentaro, Suita-shi Osaka 565-0871 (JP); NAGAI, Takabumi, Kita-ku Osaka-shi Osaka 530-8323 (JP); ADACHI, Kenji, Kita-ku Osaka-shi Osaka 530-8323 (JP)
(74) Representative: HOFFMANN EITLE
(86) International application number: PCT/JP2012/070540
(87) International publication number: WO 2013/024823

(57) **Abstract**

Provided is an etching method including: (1) bringing a material containing at least one organic compound having an N-F bond into contact with the surface of a solid material; and (2) a step of heating the solid material; whereby etching can be performed safely and in a simple manner, at a higher etching rate, without the use of a high-environmental-load gas that causes global warming or highly reactive and toxic fluorine gas or hydrofluoric acid. The etching method may further include: (3) a step of exposing the solid material to light from the side of the material containing at least one organic compound having an N-F bond; and (4) a step of removing the material containing at least one organic compound having an N-F bond together with the residue remained between said material and the solid material. In particular, performing heating at a high temperature and applying light irradiation make it possible to form inverted pyramid-shaped recesses that are suitable for applying light-trapping and/or anti-reflection processing to the surface of the solid material for a solar cell.

## Description

### Technical Field

The present invention relates to an etching method.

### Background Art

Two types of etching methods are applicable to semiconductor fabrication processes, namely dry etching and wet etching.

Generally, fluorocarbon-based gases or NF₃ used in dry etching have a high global warming potential and a considerable impact on the environment. Dry etching using a fluorine gas has also been reported (e.g., Patent Literature 1). However, fluorine gas has extremely high reactivity and toxicity, is difficult to handle and requires a scrubber for circulating alkaline water in the treatment of residue gas.

Wet etching is performed using fluoric acid, fluoronitric acid (HF-HNO₃), buffered fluoric acid or other gases. All of theses gases have high corrosiveness and toxicity so that an appropriate facility is needed for the handling thereof.

For the above-described reasons, a lithographic process using such etching methods requires numerous and complicated steps, thus increasing costs.

In order to increase the conversion efficiency due to light trapping and/or anti-reflection processing, a microscopic texture is provided on the light-receiving surface of a solar cell. The effect on conversion efficiency varies depending on the shape of the texture. It is known that greater effects can be obtained in the order of honeycomb-shaped > inverted pyramid shape > pyramid shape. All of the above shapes can be formed by etching a silicon substrate. When dry etching is employed, the equipment cost and enlargement of the surface area are issues to be addressed. When wet etching using an alkali is employed, it can be applied only to a single crystal silicon solar cell using a wafer having a (100) plane and it cannot be applied to a solar cell that uses a polycrystal or amorphous material.

Similarly, the productions of micro electro mechanical systems (MEMS), lenses, and mirrors also require a great many steps and are complicated.

Unlike the above-described conventional etching methods, etching can be performed in a safe and simple manner by forming a thin film containing at least one organic compound having an N-F bond on the solid material to be etched and exposing it to light from the thin film side, without using environmentally hazardous gases that cause global warming, or dangerous gases or fluoric acid that are highly reactive and toxic (Patent Literature 2 and 3).

### Citation List

### Patent Literature

PTL 1: JP2002-313776A
PTL 2: W02009/119848
PTL 3: JP2011-139048A

### Non-patent Literature

NPL 1: Journal of the Surface Finishing Society of Japan, 2005, Vol. 56, page 13
NPL 2: Appl. Phys. Lett., 1989, Vol. 55, page 1363
NPL 3: Sharp Technical Journal, 1998, Vol. 70, page 40

### Summary of Invention

### Technical Problem

An object of the present invention is to provide an etching method that applies the above-described etching method to achieve safe and simple etching and to increase the etching rate.

### Solution to Problem

In order to achieve the above object, the present inventors conducted extensive research and found that, by bringing an organic compound having an N-F bond into contact with a specific solid material and then heating the organic compound, etching can be performed in a safe and simple manner and the etching rate can be increased.

The present inventors also found that, when etching the solid material, the use of not only heating but also light irradiation makes it possible to more efficiently form an inverted pyramid surface shape, which is expected to render improved light-trapping and anti-reflection effects on the light-receiving surface of a solar cell, as described above. The present invention has been accomplished based on this finding and further study. More specifically, the present invention encompasses the following features.
Item 1. A method for etching a solid material comprising the steps of:
   (1) bringing a material containing at least one organic compound having an N-F bond into contact with a surface of a solid material; and
   (2) heating the solid material.
Item 2. The etching method according to Item 1, wherein the solid material is heated to 28°C or higher in step (2).
Item 3. The etching method according to Item 1 or 2, wherein the solid material is heated to 60°C or higher in step (2).
Item 4. The etching method according to Item 1 or 2, further comprising step (3) of:
   exposing the solid material to light from a side of the material containing at least one organic compound having an N-F bond.
Item 5. The etching method according to Item 3, further comprising step (3) of:
   exposing the solid material to light from a side of the material containing at least one organic compound having an N-F bond.
Item 6. The etching method according to any one of Items 1 to 5, wherein the organic compound having an N-F bond has a structural unit represented by Formula (1) below. 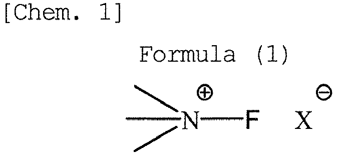 wherein

   [Chem. 2] X^{⊖}

   represents a conjugate base of a Bronsted acid.
Item 7. The etching method according to any one of Items 1 to 6, wherein the organic compound having an N-F bond is a compound represented by Formula (A1). 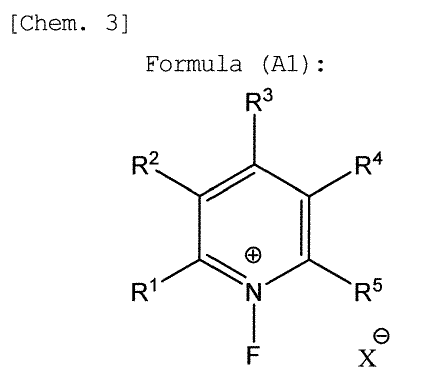
   wherein two adjacent R¹ and R², R² and R³, R³ and R⁴, or R⁴ and R⁵ may connect to each other to form -CR⁶=CR⁷-CR⁸-CR⁹-,
   R¹, R², R³, R⁴, R⁵, R⁶, R⁷, R⁸ and R⁹ may be the same or different, and each may be individually a hydrogen atom; halogen atom; nitro group; hydroxy group; cyano group; carbamoyl group; a C₁₋₁₅ alkyl group optionally substituted with at least one member selected from the group consisting of halogen atoms, hydroxy group, C₁₋₅ alkoxy groups, C₆₋₁₀ aryloxy groups, C₁₋₅ acyl groups, C₁₋₅ acyloxy groups and C₆₋₁₀ aryl groups; a C₁₋₁₅ alkenyl group optionally substituted with at least one member selected from the group consisting of halogen atoms and C₆₋₁₀ aryl groups; a C₁₋₁₅ alkynyl group optionally substituted with at least one member selected from the group consisting of halogen atoms and C₆₋₁₀ aryl groups; a C₆₋₁₅ aryl group optionally substituted with at least one member selected from the group consisting of halogen atoms and C₁₋₅ alkyl groups; a C₁₋₁₅ acyl group optionally substituted with at least one halogen atom; a C₂₋₁₅ alkoxycarbonyl group optionally substituted with at least one member selected from the group consisting of halogen atoms and C₆₋₁₀ aryl groups; a C₇₋₁₅ aryloxycarbonyl group optionally substituted with at least one member selected from the group consisting of halogen atoms and C₁₋₅ alkyl groups; a C₁₋₁₅ alkylsulfonyl group optionally substituted with at least one member selected from the group consisting of halogen atoms and C₆₋₁₀ aryl groups; a C₆₋₁₅ arylsulfonyl group optionally substituted with at least one member selected from the group consisting of halogen atoms and C₁₋₅ alkyl groups; a C₁₋₁₅ alkylsulfinyl group optionally substituted with at least one member selected from the group consisting of halogen atoms and C₆₋₁₀ aryl groups; a C₆₋₁₅ arylsulfinyl group optionally substituted with at least one member selected from the group consisting of halogen atoms and C₁₋₅ alkyl groups; a C₁₋₁₅ alkoxy group optionally substituted with at least one member selected from the group consisting of halogen atoms and C₆₋₁₀ aryl groups; a C₆₋₁₅ aryloxy group optionally substituted with at least one member selected from the group consisting of halogen atoms and C₁₋₅ alkyl groups; a C₁₋₁₅ acyloxy group optionally substituted with at least one halogen atom; a C₁₋₁₅ acylthio group optionally substituted with at least one halogen atom; a C₁₋₁₅ alkanesulfonyloxy group optionally substituted with at least one member selected from the group consisting of halogen atoms and C₆₋₁₀ aryl groups; a C₆₋₁₅ arylsulfonyloxy group optionally substituted with at least one member selected from the group consisting of halogen atoms and C₁₋₅ alkyl groups; a carbamoyl group optionally substituted with at least one member selected from the group consisting of C₁₋₅ alkyl groups and C₆₋₁₀ aryl groups; an amino group optionally substituted with at least one member selected from the group consisting of C₁₋₅ acyl groups and halogen atoms; a C₆₋₁₅ N-alkylpyridinium base optionally substituted with at least one member selected from the group consisting of halogen atoms, C₆₋₁₀ aryl groups and C₁₋₅ alkyl groups; a C₁₁₋₁₅ N-arylpyridinium base optionally substituted with at least one member selected from the group consisting of halogen atoms, C₆₋₁₀ aryl groups and C₁₋₅ alkyl groups; or an organic polymer chain,
   wherein R¹, R², R³, R⁴, R⁵, R⁶, R⁷, R⁸ and R⁹ may form a ring structure in various combinations with or without having a hetero atom therebetween,
   wherein

      [Chem. 4] X^{⊖}

      represents a conjugate base of a Bronsted acid.
Item 8. The etching method according to any one of Items 1 to 7, wherein the solid material is a semiconductor or an insulator.
Item 9. The etching method according to any one of Items 1 to 8, wherein the solid material is at least one member selected from the group consisting of silicon, germanium, silicon germanium, silicon carbide, gallium arsenide, gallium aluminum arsenide, indium phosphide, indium antimonide, gallium nitride and aluminium nitride.
Item 10. A method for applying light-trapping and/or anti-reflection processing to a surface of a solid material for a solar cell, wherein the application method employs the etching method of any one of Items 1 to 9.
Item 11. A method for producing an etched article comprising the steps of:
   (1) bringing a material containing at least one organic compound having an N-F bond into contact with a surface of a solid material; and
   (2) heating the solid material.
Item 12. The method according to Item 11, further comprising:
   (3) exposing the solid material to light from a side of the material containing at least one organic compound having an N-F bond.
Item 13. An etched article produced by the method of Item 11 or 12.
Item 14. A silicon solar cell comprising an etched article obtained by subjecting a solid material to an etching process according to the method of Item 11 or 12, and the solid material is silicon.

### Advantageous Effects of Invention

The present invention allows etching to be performed safely and in a simple manner without using a high-environmentalload gas that causes global warming or highly reactive and toxic fluorine gas or hydrofluoric acid. Furthermore, the present invention can provide a method by which the etching rate is increased.

### Brief Description of Drawings

Fig. 1 is an SEM photograph illustrating the light irradiation effects on shapes formed by etching the surface of the solid material.
Fig. 2 is a graph showing the change in etching rate depending on the temperature in Examples 1 to 18 (p-type silicon, with light irradiation).
Fig. 3 is a graph showing the change in etching rate depending on the temperature in Examples 19 to 36 (n-type silicon, with light irradiation).
Fig. 4 is a graph showing the change in etching rate depending on the temperature in Examples 37 to 52 (p-type silicon, without light irradiation).
Fig. 5 is a graph showing the change in etching rate depending on the temperature in Examples 53 to 65 (n-type silicon, without light irradiation).
Fig. 6 is a graph showing the relationship between the time and etching depth under each temperature condition in Examples 72 to 84.
Fig. 7 is a scanning electron microscope (SEM) photograph showing the surface shape of the silicon substrate obtained in Example 85 by etching (75°C).
Fig. 8 is a scanning electron microscope (SEM) photograph showing the surface shape of the silicon substrate obtained in Example 86 by etching (100°C).
Fig. 9 is a graph showing the relationship of light irradiation intensity vs. etching time and etching depth in Examples 87 to 98.
Fig. 10 shows scanning electron microscope (SEM) photographs indicating the effects of light irradiation intensity and time on the shape of the surface of a silicon substrate after etching in Examples 87 to 98.

### Description of Embodiments

The method for etching a solid material of the present invention comprises the steps of:
(1) bringing a material containing at least one organic compound having an N-F bond into contact with the surface of a solid material; and
(2) heating the solid material.

Each step is explained below.

### Step (1)

In Step (1), a material containing at least one organic compound having an N-F bond is brought into contact with the surface of a solid material.

An organic compound having an N-F bond is known as a fluorinating agent, and is preferably a compound represented by Formula (1) : 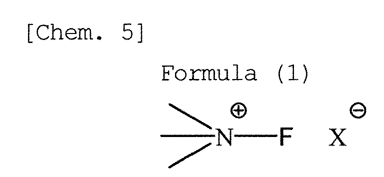 wherein

[Chem. 6] X^{⊖}

represents a conjugate base of a Bronsted acid.

Examples of the Bronsted acids that generate

[Chem. 7] X^{⊖}

include sulfonic acids, such as methanesulfonic acid, butanesulfonic acid, benzenesulfonic acid, toluenesulfonic acid, nitrobenzenesulfonic acid, dinitrobenzenesulfonic acid, trinitrobenzenesulfonic acid, trifluoromethanesulfonic acid, trifluoroethanesulfonic acid, perfluorobutanesulfonic acid, perfluorooctanesulfonic acid, perfluoro(2-ethoxyethane)sulfonic acid, perfluoro(4-ethylcyclohexane)sulfonic acid, trichloromethanesulfonic acid, difluoromethanesulfonic acid, trifluoroethanesulfonic acid, fluorosulfonic acid, chlorosulfonic acid, camphorsulfonic acid, bromocamphorsulfonic acid, Δ⁴-cholesten-3-one-6-sulfonic acid, 1-hydroxy-p-menthon-2-sulfonic acid, p-styrenesulfonic acid, β-styrenesulfonic acid, vinylsulfonic acid and perfluoro-3,6-dioxa-4-methyl-7-octenesulfonic acid; mineral acids, such as sulfuric acid, phosphoric acid and nitric acid; halide acids, such as perchloric acid, perbromic acid, periodic acid, chloric acid and bromic acid; monoalkyl sulfuric acids, such as monomethyl sulfuric acid and monoethyl sulfuric acid; carboxylic acids, such as acetic acid, formic acid, trichloroacetic acid, trifluoroacetic acid, pentafluoropropionic acid, dichloroacetic acid and acrylic acid; compounds of Lewis acids and hydrogen halides, such as HAlF₄, HBF₄, HB₂F₇, HPF₆, HSbF₄, HSbF₆, HSb₂F₁₁, HAsF₆, HAlCl₄, HAlCl₃F, HAlF₃Cl, HBCl₄, HBCl₃F, HBBr₃F, HSbCl₆ and HSbCl₅F; aryl-substituted boron compounds, such as HBPh₄ (Ph is a phenyl group) and compounds shown below; 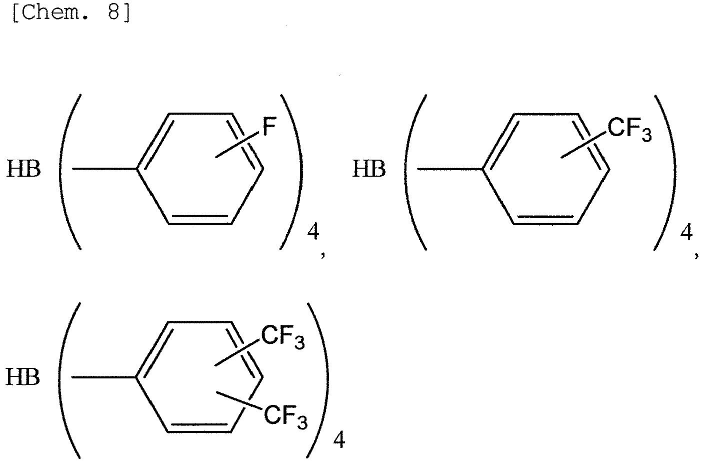 acid amide compounds, such as (FSO₂)₂NH, (PhSO₂)₂NH (Ph is a phenyl group), (CF₃SO₂)₂NH, (C₂F₅SO₂)₂NH, (C₄F₉SO₂)₂NH, (HCF₂CF₂SO₂)₂NH, CF₃SO₂NHSO₂C₆F₁₃, 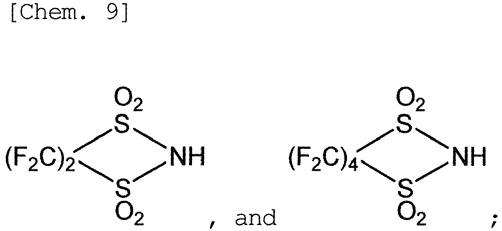 and carbon acid compounds, such as (FSO₂)₃CH, (CF₃SO₂)₃CH, (PhOSO₂)₃CH (Ph is a phenyl group), (CF₃SO₂)₂CH₂, (CF₃SO₂)₃CH, (C₄F₉SO₂)₃CH and (C₈F₁₇SO₂)₃CH.

In order to obtain a highly stable organic compound having an N-F bond, as

[Chem. 10] X^{⊖},

the use of a conjugate base of a Bronsted acid having a stronger acidity than acetic acid (pKa: 4.56) is preferable.

Particularly preferable examples of the conjugate bases include ⁻BF₄, ⁻PF₆, ⁻AsF₆, ⁻SbF₆, ⁻AlF₄, ⁻AlCl₄, ⁻SbCl₆, ⁻SbCl_{S}F, ⁻Sb₂F₁₁, ⁻B₂F₇, ⁻OClO₃, ⁻OSO₂F, ⁻OSO₂Cl, ⁻OSO₂OH, ⁻OSO₂OCH₃, ⁻OSO₂CH₃, ⁻OSO₂CF₃, ⁻OSO₂CCl₃, ⁻OSO₂C₄F₉, ⁻OSO₂C₆H₅, ⁻OSO₂C₆H₄CH₃, ⁻OSO₂C₆H₄NO₂ and ⁻N(SO₂CF₃)₂. Among these, tetrafluoroborate (⁻BF₄) and perfluoroalkane sulfonates (e.g., ⁻OSO₂CF₃ and ⁻OSO₂C₄F₉) are particularly preferable, and tetrafluoroborate (⁻BF₄) is yet more preferable.

Examples of the organic compounds having an N-F bond that satisfy Formula (1) include N-fluoropyridinium compound (A), N-fluoroquinuclidinium salt (B) and N-fluoro-1,4-diazoniabicyclo[2.2.2]octane compound (C).

Preferable examples of N-fluoropyridinium compound (A) include the compounds represented by Formula (A1), (A2), or (A3).

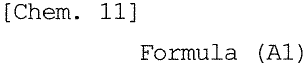

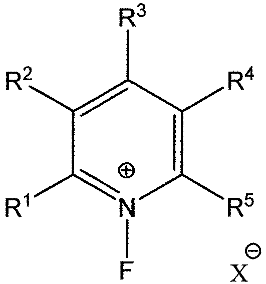

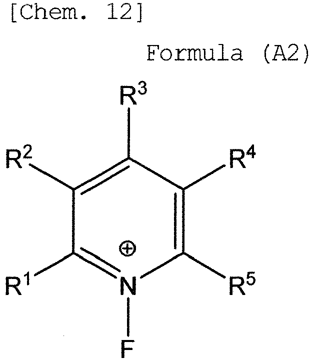

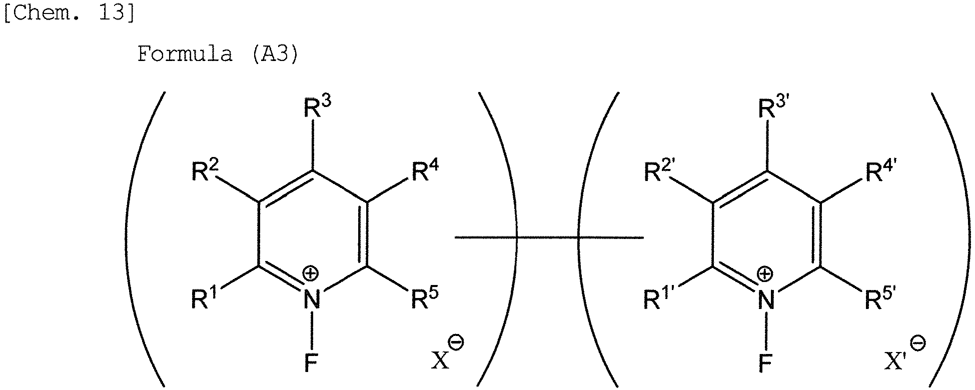

In Formulas (A1) to (A3), two adjacent R¹ and R², R² and R³, R³ and R⁴, or R⁴ and R⁵ may connect to each other to form -CR⁶= CR⁷-CR⁸=CR⁹-. Alternatively, R¹' and R²', R²' and R³', R³' and R⁴', or R⁴' and R⁵' may connect to each other to form -CR⁶' =CR⁷' -CR⁸' = CR⁹'-,
R³ R¹, R², R³, R⁴, R⁵ R⁶, R⁷ R⁸, R⁹ R¹', R²', R³', R⁴', R⁵', R⁶', R⁷', R⁸' and R⁹' may be the same or different, and each may be individually a hydrogen atom; halogen atom; nitro group; hydroxy group; cyano group; carbamoyl group; a C₁₋₁₅ alkyl group optionally substituted with at least one member selected from the group consisting of halogen atoms, hydroxy groups, C₁₋₅ alkoxy groups, C₆₋₁₀ aryloxy groups, C₁₋₅ acyl groups (e.g., alkanoyl group), C₁₋₅ acyloxy groups (e.g., alkanoyloxy group), and C₆₋₁₀ aryl groups; a C₁₋₁₅ alkenyl group optionally substituted with at least one member selected from the group consisting of halogen atoms and C₆₋₁₀ aryl groups; a C₁₋₁₅ alkynyl group optionally substituted with at least one member selected from the group consisting of halogen atoms and C₆₋₁₀ aryl groups; a C₆₋₁₅ aryl group optionally substituted with at least one member selected from the group consisting of halogen atoms and C₁₋₅ alkyl groups; a C₁₋₁₅ acyl group (e.g., alkanoyl group) optionally substituted with at least one halogen atom; a C₂₋₁₅ alkoxycarbonyl group optionally substituted with at least one member selected from the group consisting of halogen atoms and C₆₋₁₀ aryl groups; a C₇₋₁₅ aryloxycarbonyl group optionally substituted with at least one member selected from the group consisting of halogen atoms and C₁₋₅ alkyl groups; a C₁₋₁₅ alkylsulfonyl group optionally substituted with at least one member selected from the group consisting of halogen atoms and C₆₋₁₀ aryl groups; a C₆₋₁₅ arylsulfonyl group optionally substituted with at least one member selected from the group consisting of halogen atoms and C₁₋₅ alkyl groups; a C₁₋₁₅ alkylsulfinyl group optionally substituted with at least one member selected from the group consisting of halogen atoms and C₆₋₁₀ aryl groups; a C₆₋₁₅ arylsulfinyl group optionally substituted with at least one member selected from the group consisting of halogen atoms and C₁₋₅ alkyl groups; a C₁₋₁₅ alkoxy group optionally substituted with at least one member selected from the group consisting of halogen atoms and C₆₋₁₀ aryl groups; a C₆₋₁₅ aryloxy group optionally substituted with at least one member selected from the group consisting of halogen atoms and C₁₋₅ alkyl groups; a C₁₋₁₅ acyloxy group (e.g., alkanoyloxy group) optionally substituted with at least one halogen atom; a C₁₋₁₅ acylthio group (e.g., alkanoylthio group) optionally substituted with at least one halogen atom; a C₁₋₁₅ alkanesulfonyloxy group optionally substituted with at least one member selected from the group consisting of halogen atoms and C₆₋₁₀ aryl groups; a C₆₋₁₅ arylsulfonyloxy group optionally substituted with at least one member selected from the group consisting of halogen atoms and C₁₋₅ alkyl groups; a carbamoyl group optionally substituted with at least one member selected from the group consisting of C₁₋₅ alkyl groups and C₆₋₁₀ aryl groups; an amino group optionally substituted with at least one member selected from the group consisting of C₁₋₅ acyl groups and halogen atoms; a C₆₋₁₅ N-alkylpyridinium base optionally substituted with at least one member selected from the group consisting of halogen atoms, C₆₋₁₀ aryl groups and C₁₋₅ alkyl groups; a C₁₁₋₁₅ N-arylpyridinium base optionally substituted with at least one member selected from the group consisting of halogen atoms, C₆₋₁₀ aryl groups and C₁₋₅ alkyl groups; or an organic polymer chain,
wherein R¹, R², R³, R⁴, R⁵, R⁶, R⁷, R⁸, R⁹, R¹, R², R³, R⁴', R⁵', R⁶', R⁷', R⁸' and R⁹' may form a ring structure in various combinations with or without having a hetero atom therebetween.

In Formula (A2), one of R¹, R², R³, R⁴, R⁵, R⁶, R⁷, R⁸ and R⁹ is shown below:

[Chem. 14] -RSO₃^{⊖}

wherein R is a single bond or C₁₋₅ alkylene group.

In Formula (A3), one of R¹, R², R³, R⁴, R⁵, R⁶, R⁷, R⁸ and R⁹ binds to one of R¹', R²', R³', R⁴', R⁵', R⁶', R⁷', R⁸' and R⁹' via a single bond to form a joining chain;

[Chem. 15] X^{⊖}

is the same as defined in Formula (1); and

[Chem. 16] X'^{⊖}

is the same as X^{⊖}.

Among the N-fluoropyridinium salts (A) used in the present invention, a particularly preferable compound is at least one N-fluoropyridinium salt selected from the group consisting of Compounds (A1a) represented by Formula (A1a): 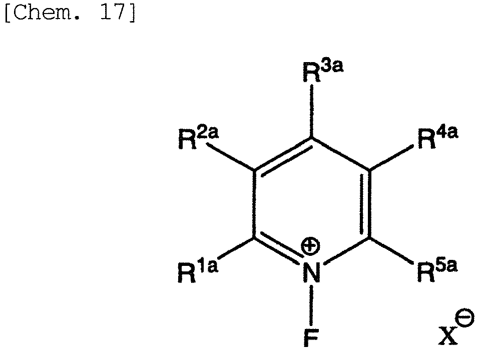 wherein R^{1a}, R^{2a}, R^{3a}, R^{4a} and R^{5a} may be the same or different, and each individually represents a hydrogen atom, C₁₋₄ alkyl group, C₁₋₄ haloalkyl group, halogen atom, unsubstituted or methyl- or halogen-substituted phenyl group, C₁₋₄ alkoxy group, C₂₋₄ acyl group (e.g., alkanoyl group), C₂₋₄ acyloxy group (e.g., alkanoyloxy group), C₂₋₄ alkoxycarbonyl group, cyano group or nitro group;
wherein

[Chem. 18] X^{⊖}

is a conjugate base of a Bronsted acid having a pKa of 4.56 or less; and
Compounds (A2a) represented by Formula (A2a): 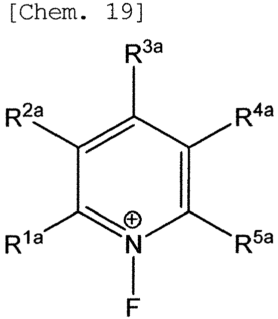 wherein one of R^{1a}, R^{2a}, R^{3a}, R^{4a}, and R^{5a} is as follows:

[Chem. 20] (CH₂)ᵣSO₃^{⊖}

wherein r is an integer of 0 to 5, and preferably 0 to 2, the remaining portions are the same or different and each individually a hydrogen atom, a C₁₋₄ alkyl group, a C₁₋₄ haloalkyl group or a halogen atom.

The preferable compounds also include Compound (A3a) represented by Formula (A3a) below: 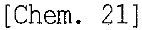 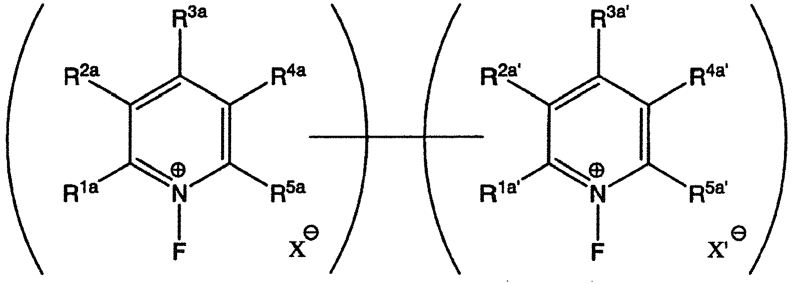 wherein R^{1a}, R^{2a}, R^{3a}, R^{4a}, R^{5a} R^{1a'}, R^{2a'}, R^{3a'}, R^{4a'} and R^{5a'} may be the same or different, and each individually represents a hydrogen atom, C₁₋₄ alkyl group, C₁₋₄ haloalkyl group, halogen atom, unsubstituted or methyl- or halogen-substituted phenyl group, C₁₋₄ alkoxy group, C₂₋₄ acyl group (e.g., alkanoyl group), C₂₋₄ acyloxy group (e.g., alkanoyloxy group), C₂₋₄ alkoxycarbonyl group, cyano group or nitro group,
wherein one of R^{1a}, R^{2a}, R^{3a}, R^{4a} and R^{5a} binds to one of R^{1a'}, R^{2a'}, R^{3a}', R^{4a'} and R^{5a'} via a single bond to form a joining chain,
wherein

[Chem. 22] X^{⊖} or X'^{⊖}

is a conjugate base of a Bronsted acid having a pKa of 4.56 or less.

In the compounds represented by Formulas (A1a), (A2a) and (A3a), the higher the electron-donating power that R^{1a}, R^{2a}, R^{3a}, R^{4a}, R^{5a}, R^{1a'}, R^{2a'}, R^{3a'}, R^{4a'} and R^{5a'} have, the more stable the compounds tend to become, and the higher the electron-withdrawing power that R^{1a}, R^{2a}, R^{3a}, R^{4a}, R^{5a}, R^{1a'}, R^{2a'}, R^{3a'}, R^{4a'} and R^{5a} have, the more reactive they tend to become. Considering this fact, R^{1a}, R^{2a}, R^{3a}, R^{4a}, R^{5a}, R^{1a'}, R^{2a'}, R^{3a'}, R^{4a'} and R^{5a'} may be suitably selected depending on the properties required.

A particularly preferable example for the N-fluoroquinuclidinium salt (B) is a compound represented by Formula (B) below: 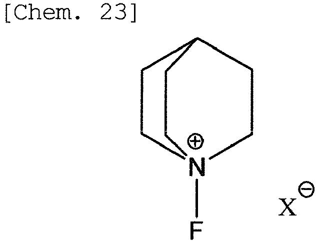 wherein

[Chem. 24] X^{⊖}

is the same as defined in Formula (1).

A particularly preferable example for the N-fluoro-1,4-diazoniabicyclo[2.2.2]octane compound (C) is a compound represented by Formula (C): 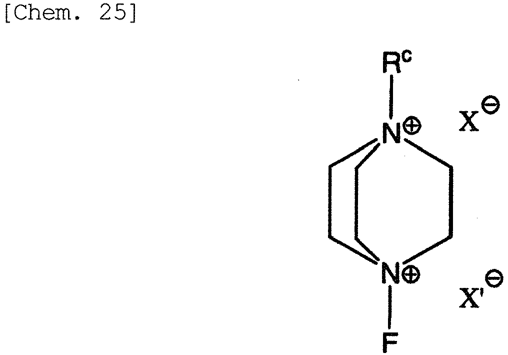 wherein R^{c} is a hydroxy group, C₁₋₅ alkyl group, C₁₋₅ haloalkyl group, or C₆₋₁₀ aryl group; and
wherein

[Chem. 26] X^{⊖} and X'^{⊖}

may be the same or different and each is the same as that in Formula (1).

Among these organic compounds having an N-F bond, N-fluoropyridinium compound (A) is preferable in that it has an aromatic ring skeleton that can easily receive electrons.

In the present invention, the organic compounds having an N-F bond may be used singly or in a combination of two or more. When two or more organic compounds having an N-F bond are used in a combination, the above-mentioned organic compounds having an N-F bond may be combined as desired. In particular, the use of two or more N-fluoropyridinium compounds (A) in a combination allows step (1) to be readily performed because this lowers the melting point and allows the compounds to be formed into a liquid at room temperature, so that it can be applied without further treatment when coated.

There is no limitation to the composition ratio when two or more organic compounds having an N-F bond are used in a combination. Preferably, the composition ratio is selected in such a manner that it can lower the melting point and allow the compounds to be formed into a liquid at room temperature. In this case, each component is preferably contained in a percentage of about 1 to 99% by mass.

Furthermore, these organic compounds having an N-F bond are preferably combined with the second components that are compatible with these organic compounds in order to improve the functions thereof. For example, by adding an ionic liquid, viscosity of the film, uniformity, ease of application, adhesion such as wettability on a solid material, etc., can be suitably adjusted.

Specific examples of ionic liquids include imidazolium salts, pyridinium salts, ammonium salts, phosphonium salts and other compounds listed in the reagent catalogs having ionic liquids available from Sigma-Aldrich or the reagent catalogs having aliphatic ionic liquids available from Kanto Chemical Co., Inc.

For example, in order to improve the adhesion to a hydrogen-terminated silicon substrate, the use of counter cations or counter anions having a long alkyl chain, or such ions with a relatively high molecular weight is preferable.

Specific examples thereof include 1-hexadecyl-3-methylimidazolium tetrafluoroborate, 1-ethyl-3-methylimidazolium tetrafluoroborate, 1-hexadecyl-3-methylimidazolium chloride, 1-hexylpyridinium trifluoromethanesulfonate and trihexyl(tetradecyl)phosphonium dicyanamide.

Examples of the second components include organic solvents, polymers, oils and other components that are highly compatible with the organic compound having an N-F bond.

Examples of the organic solvents include acetonitrile, propionitrile, benzonitrile, methyl ethyl ketone, t-butyl methyl ketone, acetone, methyl acetate, ethyl acetate, methyl formate, ethyl formate, diethyl ether, diisopropyl ether, tetrahydrofuran, 2-methyltetrahydrofuran, dioxane, 1,3-dioxolane, dimethoxyethane, diethylene glycol dimethyl ether, triethylene glycol dimethyl ether, tetraethylene glycol dimethyl ether, dimethyl carbonate, diethyl carbonate, ethyl methyl carbonate, ethylene carbonate, propylene carbonate, γ-butyrolactone, γ-valerolactone, sulfolane and methylsulfolane.

Examples of the polymers include hydrophilic polymers containing polar groups in molecules, such as polyvinyl alcohols, polyoxyalkylene and ion exchange polymers, and fluorine-containing alkyl ether polymers that are compatible with the organic compound having an N-F bond.

The oils may be animal or vegetable oils, such as squalene and fatty acid ester; or synthetic oils, such as silicone oils composed of dimethylsiloxane, etc.

Examples of the solid materials include semiconductors and insulators. Examples of the semiconductors include silicon (e.g., single crystalline silicon, polycrystalline silicon, and amorphous silicon), germanium, silicon germanium, silicon carbide (SiC), gallium arsenide, gallium aluminum arsenide, indium phosphide, indium antimonide, gallium nitride and aluminium nitride. Examples of the insulators include metal oxides such as zirconium oxide, hafnium oxide, tantalum oxide, aluminium oxide, titanium oxide and chrome oxide; silicon oxides such as silicates of the above-mentioned oxides, silicon dioxide, quartz; silicon nitrides, sapphire and the like. Among these, silicon (e.g., single crystalline silicon, polycrystalline silicon and amorphous silicon), germanium, gallium arsenide, gallium nitride, indium phosphide, and the like are preferable in view of increasing the etching rate.

There is no limitation to the surface shapes or the like of these solid materials.

The organic compound having an N-F bond contained in the material containing an organic compound having an N-F bond that was brought into contact with the solid material in step (1) can be used in any form of crystal, polycrystal, amorphous, or liquid; however, amorphous or liquid is preferable in order to enable a smooth reaction with the solid material.

A specific example of the process of bringing the material containing an organic compound having an N-F bond into contact with the surface of the solid material is one in which the organic compound having an N-F bond is dissolved in a solvent, applied to the surface of the solid material, and, if necessary, the solvent may be removed.

The use of an organic compound having an N-F bond that is in a liquid form or that can be liquefied by heating or the like allows easy application thereof to the surface of the solid material.

When a solvent is used, there is no particular limitation thereof. Examples include acetonitrile, propionitrile, benzonitrile, methyl ethyl ketone, t-butyl methyl ketone, acetone, methyl acetate, ethyl acetate, methyl formate, ethyl formate, diethyl ether, diisopropyl ether, tetrahydrofuran, 2-methyltetrahydrofuran, dioxane, 1,3-dioxolane, dimethoxyethane, diethylene glycol dimethyl ether, triethylene glycol dimethyl ether, tetraethylene glycol dimethyl ether, dimethyl carbonate, diethyl carbonate, ethyl methyl carbonate, ethylene carbonate, propylene carbonate, γ-butyrolactone, γ-valerolactone, sulfolane and methylsulfolane. Among these, acetonitrile, acetone, tetrahydrofuran and dimethoxyethane are preferable since the organic compound having an N-F bond is highly soluble in these solvents.

The method for bringing the material containing an organic compound having an N-F bond into contact with a solid material is not particularly limited. Examples of the usable coating methods include casting, spin coating, dip coating, spraying, inkjet printing and doctor blade coating. The application thereof can also be performed by impregnating a solid material with a liquefied material containing an organic compound having an N-F bond. When a coating method is employed, the entire surface of the solid material may be coated or only a part thereof may by coated. In the case where the surface of the solid material is partially coated, the coating is preferably performed by spray coating using a mask or by inkjet printing.

The thickness of the film formed from a material comprising the organic compound having an N-F bond is not particularly limited. In order to sufficiently etch the solid material, the thickness is preferably in the range of 100 nm to 50 mm, and more preferably in the range of 200 nm to 10 mm. When deep etching is to be performed, the film is preferably thickly formed.

When a solvent is used in step (1), the method for removing the solvent is not particularly limited. Examples of the applicable methods include that the removal is performed by a heat treatment conducted at 0.1 kPa to 0.1 MPa and at 25 to 100°C. Alternatively, the removal may also be conducted by blowing air under the conditions of room temperature (about 20°C) and ordinary pressure (about 0.1 MPa).

Here, if the temperature is set at 25°C or higher (preferably, 28°C or higher), not only the removal of solvent but also step (2) described later can be performed simultaneously.

When the organic compound having an N-F bond can be liquefied by heating, although it depends on the melting point, solidifying point, or the like of the compound, the heating temperature is preferably 0 to 150°C. Alternatively, liquefaction is preferably performed by mixing an organic compound having an N-F bond with a different structure, or ionic liquid, organic solvent, organic acid salt, amine salt or other materials that are compatible with the organic compound having an N-F bond to lower the melting point.

As a specific example, when N-fluoro-3-methylpyridinium tetrafluoroborate (melting point: 59°C) and N-fluoro-4-methylpyridinium tetrafluoroborate (melting point: 66°C) are mixed in a mass ratio of 2:1, the melting point is lowered to -17°C. This indicates that mixing at least two organic compounds having an N-F bond is effective when they are used in a liquid form.

When a material containing an organic compound having an N-F bond is brought into contact with the surface of a solid material by the method described above, if the material is in the form of a liquid or contains a liquid, the material may be dried thereafter. The conditions for drying can be suitably controlled depending on the organic compound having an N-F bond used.

The material containing an organic compound having an N-F bond may be solidified by cooling after being liquefied by heating and brought into contact with the solid material. In this case, the heating temperature is not limited as long as it does not exceed the melting point of the organic compound having an N-F bond, and the cooling temperature is not limited as long as it is equal to or below the solidifying point.

### Step (2)

The heating temperature is not particularly limited as long as it exceeds room temperature (20°C) and is preferably 25°C or higher, more preferably 60°C or higher, and still more preferably 75°C or higher. If step (3) (exposure to light) described later is conducted, the temperature is preferably 25°C or higher, and when step (3) is not conducted, 28°C or higher is preferable. In either case where step (3) is conducted or not conducted, by setting the heating temperature at 60°C or higher (preferably 75°C or higher, and more preferably 150°C or higher), the etching rate can be further increased and deeper etching can be performed. There is no particular lower limitation for the heating temperature, but the heating temperature is preferably equal to or lower than the decomposition temperature of the organic compound having an N-F bond used. Specifically, the heating temperature is preferably 250°C or lower and more preferably 200°C or lower.

The heating time is not particularly limited, and may be suitably selected depending on the etching depth necessary. Specifically, about 5 minutes to 10 hours is preferable. This allows more efficient forming of inverted pyramids on the surface, which is effective for achieving a light-trapping and/or anti-reflection effect. When the heating temperature is lower than 60°C, the heating time is preferably about 30 minutes to 2 hours, and when the heating temperature is 60°C or higher, the heating time is preferably about 10 to 30 minutes. When step (3) (exposure to light) described later is performed, heating is preferably maintained during light exposure.

The heating method is not particularly limited and conventionally used methods can be employed. Examples of the usable means include a hot plate, Peltier device, water bath, oil bath, thermostat, thermo-hygrostat, dryer, incubator, heating furnace, electric furnace, infrared radiation, and the like.

This step allows the etching rate to be increased on the entire surface of the solid material with which a material comprising at least one organic compound having an N-F bond was brought into contact.

The reaction mechanism is not very clear; however, for example, when the solid material is silicon, the reaction mechanism is presumably as follows. Due to an increase in temperature, the electron transfer between the organic compound having an N-F bond and silicon becomes active, facilitating etching due to the fluorination of silicon at the interface. Note that, under a high temperature (more specifically, 60°C or higher), the viscosity of a compound having an N-F bond lowers and easily flows. This allows the surface of the silicon to be constantly in contact with an active compound having an N-F bond.

Considering the above mechanism, if the material is placed under the condition where fluoride derived from the solid material can be easily removed, the etching rate can be increased. Specifically, etching conducted under reduced pressure can increase the etching rate.

### Step (3)

In the present invention, when conducting step (2) (heating), the solid material may be exposed to light from the side of the material containing an organic compound having an N-F bond either simultaneously or in a separate step. However, the process is simplified by simultaneous heating and light exposure. When the heating temperature is lower than 150°C, further improvement in etching rate can be expected. More specifically, as exemplified in the application of texturisation on the surface of a solar cell described below, a sufficient etching rate can be achieved at 60°C or higher.

As described above, by performing light exposure in step (3), the portion exposed to light can be etched more effectively without the need for developing. This is because electron movement from the solid material to the organic compound having an N-F bond becomes very easy due to electron excitation caused by light irradiation and, therefore, etching can be performed at a very high rate.

Furthermore, by adjusting the intensity of light irradiation in a stepwise manner, it becomes possible to process a structure having a shape other than a linear shape. More specifically, a slanted surface, curved-surfaced structure and others can be created. In a similar manner, when the temperature on the substrate is varied using two or more heater types during the etching process, the formation of a more complicated shape becomes feasible.

In contrast, when the heating temperature is 150°C or higher, there is no significant difference in the etching rate with or without the conduction of step (3) (exposure to light).

However, the surface condition of the etched article changes with or without the conduction of step (3) (exposure to light).

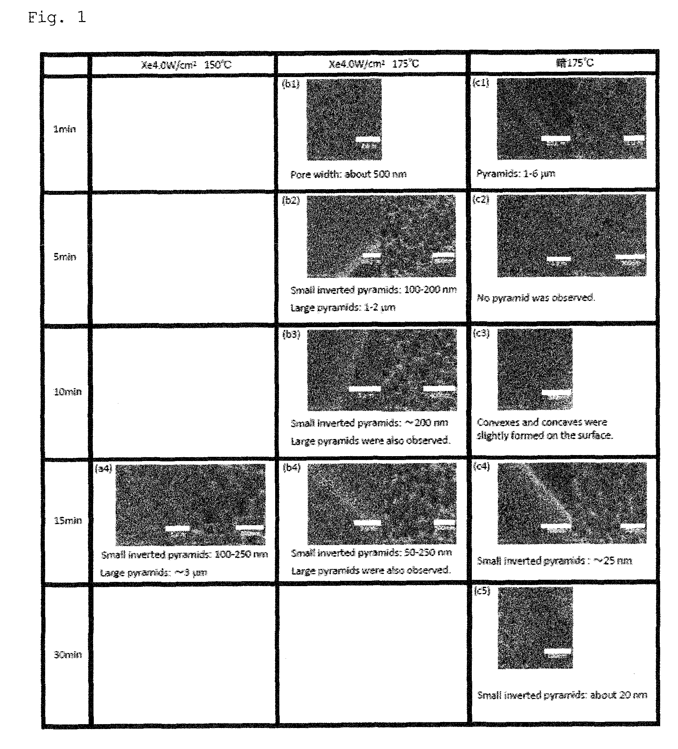

More specifically, when Step (3) (exposure to light) is not conducted, as shown in Figs. 1 (c1) to (c5), relatively large convexes each having a pyramid shape in a size of about 1 to 6 µm are formed at an initial stage, and then the pyramid-shaped convexes disappear. When etching is further continued, small concave portions having an inverted pyramid shape in a size of about 20 to 30 nm are formed on the entire surface.

In contrast, when step (3) (exposure to light) is conducted, for example, under the conditions shown in Figs. 1 (a4) and (b1) to (b4), pores each having a size of about 300 to 700 nm are formed on the entire surface at the initial stage and then relatively -shaped convex portions are formed. Eventually, pyramid-shaped convex portions are formed, each pyramid-shaped convex portions having a size of about 1 to 3 µm with inverted pyramid-shaped concave portions in a size of about 100 to 300 nm formed on the entire surface thereof.

Other than those described above, a second processing step is preferably conducted prior to the step for removing the material containing an organic compound having an N-F bond from the solid material. According to this continuous etching operation, processing a complicated shape can be completed by a single step. The advantageous effects achieved by the process for processing solid material described above cannot be attained by any ordinary etching operation.

Examples of the exposure method include irradiation of visible light, ultraviolet light, infrared light, X-rays, an electron beam, an ion beam, a laser beam, or the like. Here, the entire surface of the thin film may be irradiated. When the surface of the thin film is partially irradiated, a mask may be used and the use of a projector, etc., also allows a target portion to be irradiated in a simple manner. Among the examples mentioned above, the irradiation of visible light or ultraviolet light is preferable. When X-rays are used, spatial resolution can be enhanced.

Here, visible light has a wavelength of about 400 to 800 nm; ultraviolet light has a wavelength of about 10 to 400 nm; infrared light has a wavelength of about 800 nm to 25 µm; X-rays have a wavelength of about 0.01 to 70 nm; an electron beam has an acceleration voltage of about 0.1 kV to 200 kV; and an ion beam has an acceleration voltage of about 1 kV to 200 kV. A laser beam is excellent in that it can accurately and easily control the light irradiation area; therefore, a laser beam is usable regardless of its pulse width, output, wavelength, oscillation system and medium.

The exposure intensity is preferably 0.001 to 100 W/mm² and more preferably 0.01 to 10 W/mm². The exposure time is preferably 1 second to 24 hours and more preferably 10 seconds to 5 hours. The exposure amount is preferably 0.001 to 100 W·h/mm² and more preferably 0.01 to 10 W·h/mm².

### Step (4)

After etching the solid material as described above, a solid material etched into a desirable shape may be obtained by performing step (4) below.
(4) removing the material containing an organic compound having an N-F bond together with the residue remained between the material and the solid material.

Although the method is not particularly limited, specific examples of the method for removing the material containing an organic compound having an N-F bond include immersion in an organic solvent, such as acetonitrile, propionitrile, benzonitrile, methyl ethyl ketone, t-butyl methyl ketone, acetone, methyl acetate, ethyl acetate, methyl formate, ethyl formate, diethyl ether, diisopropyl ether, tetrahydrofuran, 2-methyltetrahydrofuran, dioxane, 1,3-dioxolane, dimethoxyethane, diethylene glycol dimethyl ether, triethylene glycol dimethyl ether, tetraethylene glycol dimethyl ether, dimethyl carbonate, diethyl carbonate, ethyl methyl carbonate, ethylene carbonate, propylene carbonate, γ-butyrolactone, γ-valerolactone, sulfolane, or methylsulfolane; spraying the organic solvent while rotating the solid material; etc.

After removing the material containing an organic compound having an N-F bond, the residue adhering to the solid material on the silicon substrate or the like can be more reliably removed by immersing the solid material in the organic solvent again, stirring if necessary, performing ultrasonic irradiation, etc.

The etching method of the present invention can be employed in semiconductor fabrication, texturisation in solar cells, micro electro mechanical system (MEMS) production, lens production, X-ray mirror production, mirror production, etc., without the use of gases with a high environmental impact that cause global warming, or dangerous gases that are highly reactive and toxic, such as fluorine gas and fluoric acid. Furthermore, the etching method of the present invention allows etching to be performed from various directions; therefore, an etched article having a more complicated shape may be etched using the same device structure easily and safely. In particular, because the etching rate can be increased by using a highly intensive light with a narrow high-temperature range using laser light or the like, this method is usable for forming the through electrodes necessary for high LSI integration, etc. Furthermore, by combining heating with light irradiation, the surface can be formed so as to have pyramid-shaped convex portions each having small inverted pyramid-shaped recesses. Having such a shape is particularly effective for applying light-trapping and/or anti-reflection processing (texturisation) to the surface of solid material for a solar cell.

In applying light-trapping and/or anti-reflection processing (texturisation: to the surface of the solid material for a solar cell, the light utilization effect changes depending on the texture shape, and it has been reported that an inverted pyramid shape is more preferable than a pyramid shape (Non-Patent Literature 1 and 2). It is also known that the concavo-convex pattern width is preferably almost the same as the thickness of the substrate (e.g., silicon substrate) (Non-Patent Literature 3). Specifically, about 100 nm to 1 µm is preferable. In terms of the shape of the etched surface formed in the present invention, light irradiation under a high-temperature condition (60°C or higher) makes it possible to obtain a shape similar to that described above; therefore, it is deemed that light irradiation is preferably conducted under a high-temperature condition (60°C or higher) for applying light-trapping and/or anti-reflection processing to the surface of the solid material for a solar cell. In the texturisation, a pyramid structure can be formed by alkali etching; however, it is said that the formation of an inverted pyramid structure requires the use of a mask (Non-Patent Literature 1). A single step processing method using an etching reagent is advantageous in reducing manufacturing costs.

With regard to the texturisation in solar cells, an etching rate improvement effect achieved by light irradiation allows a sufficient processing speed to be attained when heated to a temperature of 75°C or higher. Here, a specific processing time is preferably about 5 to 30 minutes.

### Examples

The present invention is explained in detail below with reference to Examples; however, the present invention is not limited thereto.

In the following Examples, organic compounds having the N-F bonds, solid materials, and irradiation light sources shown below were used.

### Organic compound having an N-F bond

An organic compound having an N-F bond (I): N-Fluoro-3-methylpyridinium tetrafluoroborate (melting point: 59°C)

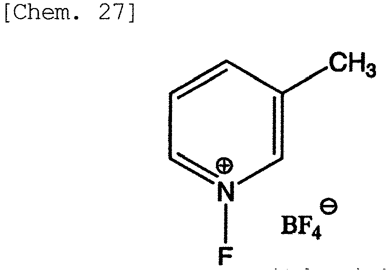

An organic compound having an N-F bond (II): N-Fluoro-4-methylpyridinium tetrafluoroborate (melting point: 66°C)

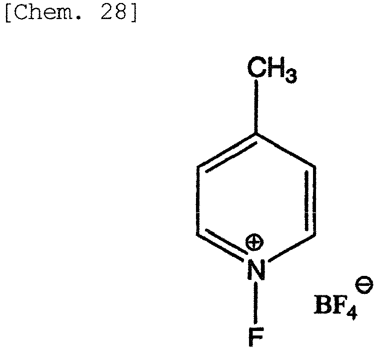

### Solid material

A silicon substrate (1): produced by a CZ method (p-type dopant: B, plane direction (100), resistivity: 10 to 20 Ω·cm, thickness: 550 µm).

A silicon substrate (2): produced by a CZ method (n-type dopant: P, plane direction (100), resistibility: 10 to 30 Ω·cm, thickness: 450 µm).

A germanium substrate: produced by a melt growth method (p-type dopant: In, plane direction (100), resistibility: 0.05 to 0.25 Ω·cm, thickness: 525±25 µm, size: 10 mm²)

A gallium-arsenide substrate: produced by an LEC (Liquid-Encapsulated Czochralski) method (Dopant: non-doped, plane direction (100), resistibility: 4.3 to 6.3 x 10⁷ Ω·cm, thickness: 350±10 µm, size: 10 mmx 10 mm)

A gallium-nitride substrate: product purchased from Powdec K.K., in which GaN was epitaxially grown on a sapphire plate (0001) with a thickness of 800 µm (Dopant: non-doped, GaN layer thickness: 2 µm, plane direction (0001) (Ga side), sheet resistance: 6000 to 10000 Ω/sq, size: 15 mm x 20 mm)

An indium phosphorus substrate: produced by a pressure-controlled Czochralski method (VCZ method) (n-type, plane direction (100), resistibility: 9.2 x 10⁻⁴ Ω·cm, thickness: 639 µm).

### Irradiation light source

Xenon lamp: Super-Quiet Xenon Lamp L2274 produced by Hamamatsu Photonics K.K., (output: 150 W, transmission wavelength: 220 to 2000 nm, irradiation intensity: 2 µw/cm² x nm⁻¹)
Halogen lamp: produced by Ushio Lighting, Inc., JCR100V150EC (wavelength range: 375 to 3500 nm)

### Example 1

### Step A: Pretreatment of substrate

A silicon substrate (1) (2 cm x 2 cm) was washed with ultrapure water for 3 minutes, and treated with 97% sulfuric acid and 30% hydrogen peroxide water (sulfuric acid:hydrogen peroxide water = 4:1 (volume ratio)) for 10 minutes to remove an organic product on the silicon substrate. The silicon substrate was washed with ultrapure water for 10 minutes, and then treated for 1 minute with dilute hydrofluoric acid to remove an oxide film on the surface. Further, the silicon substrate was treated for 10 minutes with 97% sulfuric acid and 30% hydrogen peroxide water (sulfuric acid:hydrogen peroxide water = 4:1 (volume ratio)) to make the surface hydrophilic, and finally washed with ultrapure water for 10 minutes.

### Step B: Application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to a silicon substrate, which had been pre-treated and dried according to Step A.

### Step C: Temperature control of substrate

The silicon substrate obtained in Step B on which the organic compound having an N-F bond had been applied was placed on a hot plate with cooling function (trade name: Cool Plate, As One Corporation, type: SCP125), and the plate temperature was set at 28°C. The surface temperature was detected using a temperature sensor to confirm that the temperature during the experiment was as determined.

### Step D: Light irradiation

White light (exposure wavelength: 200 to 2000 nm, exposure intensity: 0.5 W/cm²) from the xenon lamp was applied for 30 minutes to the side of the organic compound having an N-F bond in the silicon substrate whose surface temperature had been adjusted to 28°C in Step C.

### Step E: Removal of a material containing an organic compound having an N-F bond

The material that contained the organic compound having an N-F bond on the surface of the silicon substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the silicon substrate obtained in Step E was measured using a phase-shift interference microscope (NewView, produced by Zygo Corporation).

### Example 2

Example 2 was prepared in the same manner as Example 1, except that the temperature was set at 75°C in Step C. Post-treatment similar to that in Example 1 was performed, and the surface (etching depth) of the resulting silicon substrate was measured using a phase-shift interference microscope.

### Example 3

Example 3 was prepared in the same manner as Example 1, except that the temperature was set at 100°C in Step C. Post-treatment similar to that in Example 1 was performed, and the surface (etching depth) of the resulting silicon substrate was measured using a phase-shift interference microscope.

### Example 4

Example 4 was prepared in the same manner as Example 1, except that the exposure intensity was set at 1.0 W/cm² in Step D. Post-treatment similar to that in Example 1 was performed, and the surface (etching depth) of the resulting silicon substrate was measured using a phase-shift interference microscope.

### Example 5

Example 5 was prepared in the same manner as Example 1, except that the temperature was set at 75°C in Step C and the exposure intensity was set at 1.0 W/cm² in Step D. Post-treatment similar to that in Example 1 was performed, and the surface (etching depth) of the resulting silicon substrate was measured using a phase-shift interference microscope.

### Example 6

Example 6 was prepared in the same manner as Example 1, except that the temperature was set at 100°C in Step C and the exposure intensity was set at 1.0 W/cm² in Step D. Post-treatment similar to that in Example 1 was performed, and the surface (etching depth) of the resulting silicon substrate was measured using a phase-shift interference microscope.

### Example 7

Example 7 was prepared in the same manner as Example 1, except that the exposure intensity was set at 1.5 W/cm² in Step D. Post-treatment similar to that in Example 1 was performed, and the surface (etching depth) of the resulting silicon substrate was measured using a phase-shift interference microscope.

### Example 8

Example 8 was prepared in the same manner as Example 1, except that the temperature was set at 75°C in Step C and the exposure intensity was set at 1.5 W/cm² in Step D. Post-treatment similar to that in Example 1 was performed, and the surface (etching depth) of the resulting silicon substrate was measured using a phase-shift interference microscope.

### Example 9

Example 9 was prepared in the same manner as Example 1, except that the temperature was set at 100°C in Step C and the exposure intensity was set at 1.5 W/cm² in Step D. Post-treatment similar to that in Example 1 was performed, and the surface (etching depth) of the resulting silicon substrate was measured using a phase-shift interference microscope.

### Example 10

Example 10 was prepared in the same manner in Example 1, except that the exposure intensity was set at 2.0 W/cm² in Step D. Post-treatment similar to that in Example 1 was performed, and the surface (etching depth) of the resulting silicon substrate was measured using a phase-shift interference microscope.

### Example 11

Example 11 was prepared in the same manner as Example 1, except that the temperature was set at 75°C in Step C and the exposure intensity was set at 2.0 W/cm² in Step D. Post-treatment similar to that in Example 1 was performed, and the surface (etching depth) of the resulting silicon substrate was measured using a phase-shift interference microscope.

### Example 12

Example 12 was prepared in the same manner as Example 1, except that the temperature was set at 100°C in Step C and the exposure intensity was set at 2.0 W/cm² in Step D. Post-treatment similar to that in Example 1 was performed, and the surface (etching depth) of the resulting silicon substrate was measured using a phase-shift interference microscope.

### Example 13

Example 13 was prepared in the same manner as Example 1, except that the exposure intensity was set at 2.5 W/cm² in Step D. Post-treatment similar to that in Example 1 was performed, and the surface (etching depth) of the resulting silicon substrate was measured using a phase-shift interference microscope.

### Example 14

Example 14 was prepared in the same manner as Example 1, except that the temperature was set at 75°C in Step C and the exposure intensity was set at 2.5 W/cm² in Step D. Post-treatment similar to that in Example 1 was performed, and the surface (etching depth) of the resulting silicon substrate was measured using a phase-shift interference microscope.

### Example 15

Example 15 was prepared in the same manner as Example 1, except that the temperature was set at 100°C in Step C and the exposure intensity was set at 2.5 W/cm² in Step D. Post-treatment similar to that in Example 1 was performed, and the surface (etching depth) of the resulting silicon substrate was measured using a phase-shift interference microscope.

### Example 16

Example 16 was prepared in the same manner as Example 1, except that the exposure intensity was set at 3.0 W/cm² in Step D. Post-treatment similar to that in Example 1 was performed, and the surface (etching depth) of the resulting silicon substrate was measured using a phase-shift interference microscope.

### Example 17

Example 17 was prepared in the same manner as Example 1, except that the temperature was set at 75°C in Step C and the exposure intensity was set at 3.0 W/cm² in Step D. Post-treatment similar to that in Example 1 was performed, and the surface (etching depth) of the resulting silicon substrate was measured using a phase-shift interference microscope.

### Example 18

Example 18 was prepared in the same manner as Example 1, except that the temperature was set at 100°C in Step C and the exposure intensity was set at 3.0 W/cm² in Step D. Post-treatment similar to that in Example 1 was performed, and the surface (etching depth) of the resulting silicon substrate was measured using a phase-shift interference microscope.

### Example 19

Example 19 was prepared in the same manner as Example 1, except that a silicon substrate (2) (2 cm x 2 cm x 2 cm) was used as a solid material. Post-treatment similar to that in Example 1 was performed, and the surface (etching depth) of the resulting silicon substrate was measured using a phase-shift interference microscope.

### Example 20

Example 20 was prepared in the same manner as Example 1, except that a silicon substrate (2) (2 cm x 2 cm) was used as a solid material and the temperature was set at 75°C in Step C. Post-treatment similar to that in Example 1 was performed, and the surface (etching depth) of the resulting silicon substrate was measured using a phase-shift interference microscope.

### Example 21

Example 21 was prepared in the same manner as Example 1, except that a silicon substrate (2) (2 cm x 2 cm) was used as a solid material and the temperature was set at 100°C in Step C. Post-treatment similar to that in Example 1 was performed, and the surface (etching depth) of the resulting silicon substrate was measured using a phase-shift interference microscope.

### Example 22

Example 22 was prepared in the same manner as Example 1, except that a silicon substrate (2) (2 cm x 2 cm) was used as a solid material and the exposure intensity was set at 1.0 W/cm² in Step D. Post-treatment similar to that in Example 1 was performed, and the surface (etching depth) of the resulting silicon substrate was measured using a phase-shift interference microscope.

### Example 23

Example 23 was prepared in the same manner as Example 1, except that a silicon substrate (2) (2 cm x 2 cm) was used as a solid material, the temperature was set at 75°C in Step C, and the exposure intensity was set at 1.0 W/cm² in Step D. Post-treatment similar to that in Example 1 was performed, and the surface (etching depth) of the resulting silicon substrate was measured using a phase-shift interference microscope.

### Example 24

Example 24 was prepared in the same manner as Example 1, except that a silicon substrate (2) (2 cm x 2 cm) was used as a solid material, the temperature was set at 100°C in Step C, and the exposure intensity was set at 1.0 W/cm² in Step D. Post-treatment similar to that in Example 1 was performed, and the surface (etching depth) of the resulting silicon substrate was measured using a phase-shift interference microscope.

### Example 25

Example 25 was prepared in the same manner as Example 1, except that a silicon substrate (2) (2 cm x 2 cm) was used as a solid material and the exposure intensity was set at 1.5 W/cm² in Step D. Post-treatment similar to that in Example 1 was performed, and the surface (etching depth) of the resulting silicon substrate was measured using a phase-shift interference microscope.

### Example 26

Example 26 was prepared in the same manner as Example 1, except that a silicon substrate (2) (2 cm x 2 cm) was used as a solid material, the temperature was set at 75°C in Step C, and the exposure intensity was set at 1.5 W/cm² in Step D. Post-treatment similar to that in Example 1 was performed, and the surface (etching depth) of the resulting silicon substrate was measured using a phase-shift interference microscope.

### Example 27

Example 27 was prepared in the same manner as Example 1, except that a silicon substrate (2) (2 cm x 2 cm) was used as a solid material, the temperature was set at 100°C in Step C, and the exposure intensity was set at 1.5 W/cm² in Step D. Post-treatment similar to that in Example 1 was performed, and the surface (etching depth) of the resulting silicon substrate was measured using a phase-shift interference microscope.

### Example 28

Example 28 was prepared in the same manner as Example 1, except that a silicon substrate (2) (2 cm x 2 cm) was used as a solid material and the exposure intensity was set at 2.0 W/cm² in Step D. Post-treatment similar to that in Example 1 was performed, and the surface (etching depth) of the resulting silicon substrate was measured using a phase-shift interference microscope.

### Example 29

Example 29 was prepared in the same manner as Example 1, except that a silicon substrate (2) (2 cm x 2 cm) was used as a solid material, the temperature was set at 75°C in Step C, and the exposure intensity was set at 2.0 W/cm² in Step D. Post-treatment similar to that in Example 1 was performed, and the surface (etching depth) of the resulting silicon substrate was measured using a phase-shift interference microscope.

### Example 30

Example 30 was prepared in the same manner as Example 1, except that a silicon substrate (2) (2 cm x 2 cm) was used as a solid material, the temperature was set at 100°C in Step C, and the exposure intensity was set at 2.0 W/cm² in Step D. Post-treatment similar to that in Example 1 was performed, and the surface (etching depth) of the resulting silicon substrate was measured using a phase-shift interference microscope.

### Example 31

Example 31 was prepared in the same manner as Example 1, except that a silicon substrate (2) (2 cm x 2 cm) was used as a solid material and the exposure intensity was set at 2.5 W/cm² in Step D. Post-treatment similar to that in Example 1 was performed, and the surface (etching depth) of the resulting silicon substrate was measured using a phase-shift interference microscope.

### Example 32

Example 32 was prepared in the same manner as Example 1, except that a silicon substrate (2) (2 cm x 2 cm) was used as a solid material, the temperature was set at 75°C in Step C, and the exposure intensity was set at 2.5 W/cm² in Step D. Post-treatment similar to that in Example 1 was performed, and the surface (etching depth) of the resulting silicon substrate was measured using a phase-shift interference microscope.

### Example 33

Example 33 was prepared in the same manner as Example 1, except that a silicon substrate (2) (2 cm x 2 cm) was used as a solid material, the temperature was set at 100°C in Step C, and the exposure intensity was set at 2.5 W/cm² in Step D. Post-treatment similar to that in Example 1 was performed, and the surface (etching depth) of the resulting silicon substrate was measured using a phase-shift interference microscope.

### Example 34

Example 34 was prepared in the same manner as Example 1, except that a silicon substrate (2) (2 cm x 2 cm) was used as a solid material and the exposure intensity was set at 3.0 W/cm² in Step D. Post-treatment similar to that in Example 1 was performed, and the surface (etching depth) of the resulting silicon substrate was measured using a phase-shift interference microscope.

### Example 35

Example 35 was prepared in the same manner as Example 1, except that a silicon substrate (2) (2 cm x 2 cm) was used as a solid material, the temperature was set at 75°C in Step C, and the exposure intensity was set at 3.0 W/cm² in Step D. Post-treatment similar to that in Example 1 was performed, and the surface (etching depth) of the resulting silicon substrate was measured using a phase-shift interference microscope.

### Example 36

Example 36 was prepared in the same manner as Example 1, except that a silicon substrate (2) (2 cm x 2 cm) was used as a solid material, the temperature was set at 100°C in Step C, and the exposure intensity was set at 3.0 W/cm² in Step D. Post-treatment similar to that in Example 1 was performed, and the surface (etching depth) of the resulting silicon substrate was measured using a phase-shift interference microscope.

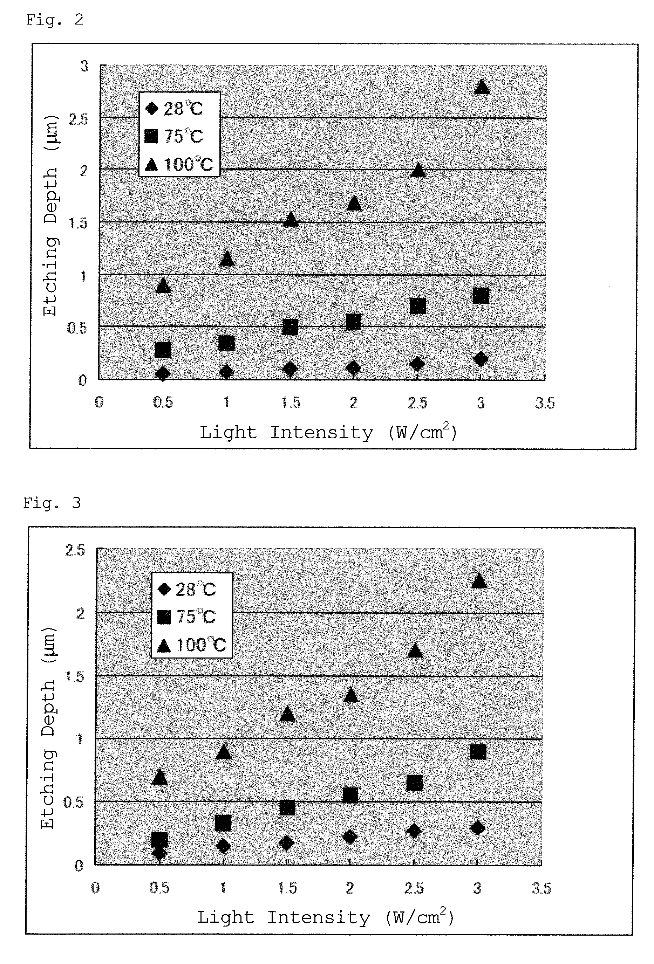

Figs. 2 and 3 show the results of Examples 1 to 36 (Fig. 2 shows the results of Examples 1 to 18 (p-type silicon, with light irradiation), and Fig. 3 shows the results of Examples 19 to 36 (n-type silicon, without light irradiation)). It was found that the etching depth of the silicon substrate increased as the temperature during irradiation as well as the light irradiation intensity increased. At 100°C, the etching of p-type silicon proceeded slightly easily compared to the etching of n-type silicon; however, almost no difference was observed at 75°C or 28°C.

Example 37 was prepared in the same manner as Example 1, except that light irradiation was not performed. Specifically, Example 37 was prepared as follows.

### Step A: Pretreatment of substrate

A silicon substrate (1) (2 cm x 2 cm) was washed with ultrapure water for 3 minutes, and treated with 97% sulfuric acid and 30% hydrogen peroxide water (sulfuric acid:hydrogen peroxide water = 4:1 (volume ratio)) for 10 minutes to remove an organic product on the silicon substrate. The silicon substrate was washed with ultrapure water for 10 minutes, and then treated for 1 minute with dilute hydrofluoric acid to remove an oxide film on the surface. Further, the silicon substrate was treated for 10 minutes with 97% sulfuric acid and 30% hydrogen peroxide water (sulfuric acid:hydrogen peroxide water = 4:1 (volume ratio)) to make the surface hydrophilic, and finally washed with ultrapure water for 10 minutes.

### Step B: Application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to the silicon substrate, which had been pre-treated and dried according to Step A.

### Step C: Temperature control of substrate

The silicon substrate obtained in Step B on which the organic compound having an N-F bond had been applied was placed on a hot plate with cooling function, and the plate temperature was set at 28°C. The silicone substrate was left in a dark room for 30 minutes. The surface temperature was detected using a temperature sensor to confirm that the temperature during the experiment was as determined.

### Step E: Removal of a material containing an organic compound

### having an N-F bond

The material that contained the organic compound having an N-F bond on the surface of the silicon substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the silicon substrate obtained in Step E was measured using a phase-shift interference microscope (NewView, produced by Zygo Corporation).

### Example 38

Example 38 was prepared in the same manner as Example 37, except that the silicon substrate obtained in Step B on which the organic compound having an N-F bond had been applied was left on a hot plate for 60 minutes in Step C. Post-treatment similar to that in Example 37 was performed, and the surface (etching depth) of the resulting silicon substrate was measured using a phase-shift interference microscope.

### Example 39

Example 39 was prepared in the same manner as Example 37, except that the silicon substrate obtained in Step B on which the organic compound having an N-F bond had been applied was left on a hot plate for 120 minutes in Step C. Post-treatment similar to that in Example 37 was performed, and the surface (etching depth) of the resulting silicon substrate was measured using a phase-shift interference microscope.

### Example 40

Example 40 was prepared in the same manner as Example 37, except that the silicon substrate obtained in Step B on which the organic compound having an N-F bond had been applied was left on a hot plate for 240 minutes in Step C. Post-treatment similar to that in Example 37 was performed, and the surface (etching depth) of the resulting silicon substrate was measured using a phase-shift interference microscope.

### Example 41

Example 41 was prepared in the same manner as Example 37, except that the silicon substrate obtained in Step B on which the organic compound having an N-F bond had been applied was placed on a hot plate set at 75°C, and left on the hot plate for 5 minutes in Step C. Post-treatment similar to that in Example 37 was performed, and the surface (etching depth) of the resulting silicon substrate was measured using a phase-shift interference microscope.

### Example 42

Example 42 was prepared in the same manner as Example 37, except that the silicon substrate obtained in Step B on which the organic compound having an N-F bond had been applied was placed on a hot plate set at 75°C, and left on the hot plate for 10 minutes in Step C. Post-treatment similar to that in Example 37 was performed, and the surface (etching depth) of the resulting silicon substrate was measured using a phase-shift interference microscope.

### Example 43

Example 43 was prepared in the same manner as Example 37, except that the silicon substrate obtained in Step B on which the organic compound having an N-F bond had been applied was placed on a hot plate set at 75°C in Step C. Post-treatment similar to that in Example 37 was performed, and the surface (etching depth) of the resulting silicon substrate was measured using a phase-shift interference microscope.

### Example 44

Example 44 was prepared in the same manner as Example 37, except that the silicon substrate obtained in Step B on which the organic compound having an N-F bond had been applied was placed on a hot plate set at 75°C, and left on the hot plate for 60 minutes in Step C. Post-treatment similar to that in Example 37 was performed, and the surface (etching depth) of the resulting silicon substrate was measured using a phase-shift interference microscope.

### Example 45

Example 45 was prepared in the same manner as Example 37, except that the silicon substrate obtained in Step B on which the organic compound having an N-F bond had been applied was placed on a hot plate set at 75°C, and left on the hot plate for 120 minutes in Step C. Post-treatment similar to that in Example 37 was performed, and the surface (etching depth) of the resulting silicon substrate was measured using a phase-shift interference microscope.

### Example 46

Example 46 was prepared in the same manner as Example 37, except that the silicon substrate obtained in Step B on which the organic compound having an N-F bond had been applied was placed on a hot plate set at 75°C, and left on the hot plate for 240 minutes in Step C. Post-treatment similar to that in Example 37 was performed, and the surface (etching depth) of the resulting silicon substrate was measured using a phase-shift interference microscope.

### Example 47

Example 47 was prepared in the same manner as Example 37, except that the silicon substrate obtained in Step B on which the organic compound having an N-F bond had been applied was placed on a hot plate set at 100°C, and left on the hot plate for 5 minutes in Step C. Post-treatment similar to that in Example 37 was performed, and the surface (etching depth) of the resulting silicon substrate was measured using a phase-shift interference microscope.

### Example 48

Example 48 was prepared in the same manner as Example 37, except that the silicon substrate obtained in Step B on which the organic compound having an N-F bond had been applied was placed on a hot plate set at 100°C, and left on the hot plate for 10 minutes in Step C. Post-treatment similar to that in Example 37 was performed, and the surface (etching depth) of the resulting silicon substrate was measured using a phase-shift interference microscope.

### Example 49

Example 49 was prepared in the same manner as Example 37, except that the silicon substrate obtained in Step B on which the organic compound having an N-F bond had been applied was placed on a hot plate set at 100°C in Step C. Post-treatment similar to that in Example 37 was performed, and the surface (etching depth) of the resulting silicon substrate was measured using a phase-shift interference microscope.

### Example 50

Example 50 was prepared in the same manner as Example 37, except that the silicon substrate obtained in Step B on which the organic compound having an N-F bond had been applied was placed on a hot plate set at 100°C, and left on the hot plate for 60 minutes in Step C. Post-treatment similar to that in Example 37 was performed, and the surface (etching depth) of the resulting silicon substrate was measured using a phase-shift interference microscope.

### Example 51

Example 51 was prepared in the same manner as Example 37, except that the silicon substrate obtained in Step B on which the organic compound having an N-F bond had been applied was placed on a hot plate set at 100°C, and left on the hot plate for 120 minutes in Step C. Post-treatment similar to that in Example 37 was performed, and the surface (etching depth) of the resulting silicon substrate was measured using a phase-shift interference microscope.

### Example 52

Example 52 was prepared in the same manner as Example 37, except that the silicon substrate obtained in Step B on which the organic compound having an N-F bond had been applied was placed on a hot plate set at 100°C, and left on the hot plate for 240 minutes in Step C. Post-treatment similar to that in Example 37 was performed, and the surface (etching depth) of the resulting silicon substrate was measured using a phase-shift interference microscope.

### Example 53

Example 53 was prepared in the same manner as Example 37, except that a silicon substrate (2) (2 cm x 2 cm) was used as a solid material, and the silicon substrate obtained in Step B on which the organic compound having an N-F bond had been applied was left on the hot plate for 60 minutes in Step C. Post-treatment similar to that in Example 37 was performed, and the surface (etching depth) of the resulting silicon substrate was measured using a phase-shift interference microscope.

### Example 54

Example 54 was prepared in the same manner as Example 37, except that a silicon substrate (2) (2 cm x 2 cm) was used as a solid material, and the silicon substrate obtained in Step B on which the organic compound having an N-F bond had been applied was left on the hot plate for 120 minutes in Step C. Post-treatment similar to that in Example 37 was performed, and the surface (etching depth) of the resulting silicon substrate was measured using a phase-shift interference microscope.

### Example 55

Example 55 was prepared in the same manner as Example 37, except that a silicon substrate (2) (2 cm x 2 cm) was used as a solid material, and the silicon substrate obtained in Step B on which the organic compound having an N-F bond had been applied was left on the hot plate for 240 minutes in Step C. Post-treatment similar to that in Example 37 was performed, and the surface (etching depth) of the resulting silicon substrate was measured using a phase-shift interference microscope.

### Example 56

Example 56 was prepared in the same manner as Example 37, except that a silicon substrate (2) (2 cm x 2 cm) was used as a solid material; and the silicon substrate obtained in Step B on which the organic compound having an N-F bond had been applied was placed on the hot plate set at 75°C, and left on the hot plate for 10 minutes in Step C. Post-treatment similar to that in Example 37 was performed, and the surface (etching depth) of the resulting silicon substrate was measured using a phase-shift interference microscope.

### Example 57

Example 57 was prepared in the same manner as Example 37, except that a silicon substrate (2) (2 cm x 2 cm) was used as a solid material, and the silicon substrate obtained in Step B on which the organic compound having an N-F bond had been applied was placed on a hot plate set at 75°C in Step C. Post-treatment similar to that in Example 37 was performed, and the surface (etching depth) of the resulting silicon substrate was measured using a phase-shift interference microscope.

### Example 58

Example 58 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 75°C, and left on the hot plate for 60 minutes in Step C. Post-treatment similar to that in Example 37 was performed, and the surface (etching depth) of the resulting silicon substrate was measured using a phase-shift interference microscope.

### Example 59

Example 59 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 75°C, and left on the hot plate for 120 minutes in Step C. Post-treatment similar to that in Example 37 was performed, and the surface (etching depth) of the resulting silicon substrate was measured using a phase-shift interference microscope.

### Example 60

Example 60 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 75°C, and left on the hot plate for 240 minutes in Step C. Post-treatment similar to that in Example 37 was performed, and the surface (etching depth) of the resulting silicon substrate was measured using a phase-shift interference microscope.

### Example 61

Example 61 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 100°C, and left on the hot plate for 10 minutes in Step C. Post-treatment similar to that in Example 37 was performed, and the surface (etching depth) of the resulting silicon substrate was measured using a phase-shift interference microscope.

### Example 62

Example 62 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 100°C in Step C. Post-treatment similar to that in Example 37 was performed, and the surface (etching depth) of the resulting silicon substrate was measured using a phase-shift interference microscope.

### Example 63

Example 63 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 100°C, and left on the hot plate for 60 minutes in Step C. Post-treatment similar to that in Example 37 was performed, and the surface (etching depth) of the resulting silicon substrate was measured using a phase-shift interference microscope.

### Example 64

Example 64 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 100°C, and left on the hot plate for 120 minutes in Step C. Post-treatment similar to that in Example 37 was performed, and the surface (etching depth) of the resulting silicon substrate was measured using a phase-shift interference microscope.

### Example 65

Example 65 was prepared in the same manner as Example 37, except that a silicon substrate (2) (2 cm x 2 cm) was used as a solid material; and the silicon substrate obtained in Step B on which the organic compound having an N-F bond had been applied was placed on a hot plate set at 100°C, and left on the hot plate for 240 minutes in Step C. Post-treatment similar to that in Example 37 was performed, and the surface (etching depth) of the resulting silicon substrate was measured using a phase-shift interference microscope.

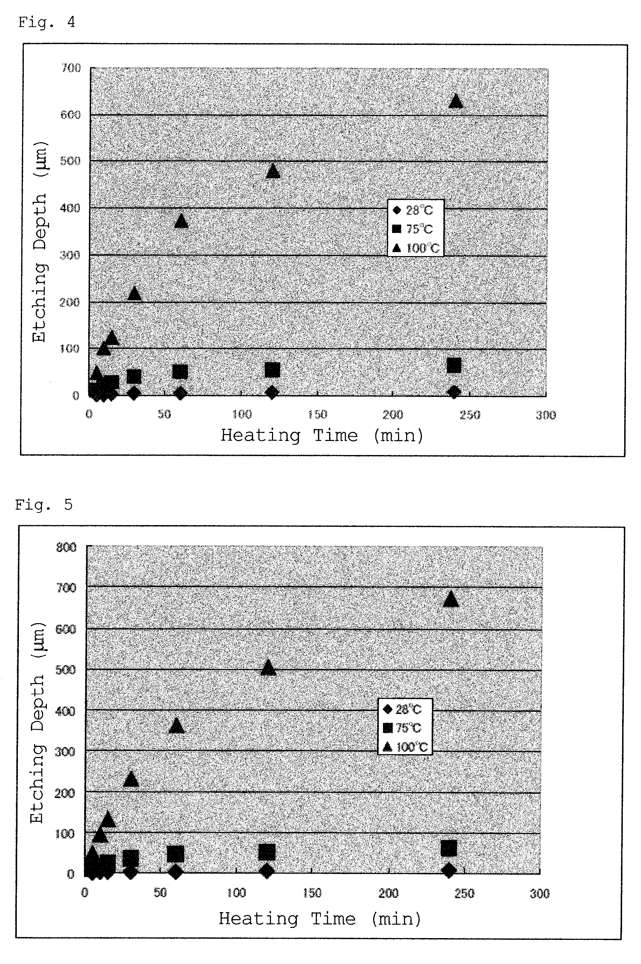

Figs. 4 and 5 show the results of Examples 37 to 65 (Fig. 4 shows the results of Examples 37 to 52 (p-type silicon, with light irradiation) and Fig. 5 shows the results of Examples 53 to 65 (n-type silicon, without light irradiation)). It was found that the higher the temperature the faster the etching proceeded. Almost no etching speed difference was observed between p-type silicon and n-type silicon at any temperature. This indicates that as the temperature increased, the reaction between the silicon and the organic compound having an N-F bond progressed, improving the etching speed of the silicon.

### Example 66

### Step A: Pretreatment of substrate

The germanium substrate was washed with ultrapure water for 3 minutes, and treated with UV ozone for 10 minutes to remove an organic product on the substrate. The substrate was washed with ultrapure water for 3 minutes, and then treated for 1 minute with dilute hydrofluoric acid to remove an oxide film on the surface. Finally, the substrate was washed with ultrapure water for 10 minutes.

### Step B: Preparation and application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to the germanium substrate, which had been pre-treated and dried according to Step A.

### Step C: Temperature control of substrate

The germanium substrate obtained in Step B on which the organic compound having an N-F bond had been applied was placed on a hot plate with cooling function (trade name: Cool Plate, As One Corporation, type: SCP125), and the plate temperature was set at 28°C. The surface temperature was detected using a temperature sensor to confirm that the temperature during the experiment was as determined.

### Step D: Light irradiation

White light (exposure wavelength: 200 to 2000 nm, exposure intensity: 3.0 W/cm²) from the xenon lamp was applied for 30 minutes to the side of the organic compound having an N-F bond in the germanium substrate whose surface temperature had been adjusted to 28°C in Step C.

### Step E: Removal of a material containing an organic compound having an N-F bond

The material that contained the organic compound having an N-F bond on the surface of the germanium substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the germanium substrate obtained in Step E was measured using a phase-shift interference microscope (NewView, produced by Zygo Corporation). The results confirmed that about 209 nm of etching was done on the germanium surface.

### Example 67

### Step A: Pretreatment of substrate

The gallium arsenide substrate was washed with ultrapure water for 3 minutes, and treated with UV ozone for 10 minutes to remove an organic product on the substrate. The substrate was washed with ultrapure water for 3 minutes, and then treated for 1 minute with dilute hydrofluoric acid to remove an oxide film on the surface. Finally, the substrate was washed with ultrapure water for 10 minutes.

### Step B: Preparation and application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to the gallium arsenide substrate, which had been pre-treated and dried according to Step A.

### Step C: Temperature control of substrate

The gallium arsenide substrate obtained in Step B on which the organic compound having an N-F bond had been applied was placed on a hot plate with cooling function (trade name: Cool Plate, As One Corporation, type: SCP125), and the plate temperature was set at 28°C. The surface temperature was detected using a temperature sensor to confirm that the temperature during the experiment was as determined.

### Step D: Light irradiation

White light (exposure wavelength: 200 to 2000 nm, exposure intensity: 3.0 W/cm²) from the xenon lamp was applied for 30 minutes to the side of the organic compound having an N-F bond in the gallium arsenide substrate whose surface temperature had been adjusted to 28°C in Step C.

### Step E: Removal of a material containing an organic compound having an N-F bond

The material that contained the organic compound having an N-F bond on the surface of the gallium arsenide substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the gallium arsenide substrate obtained in Step E was measured using a phase-shift interference microscope (NewView, produced by Zygo Corporation). The results confirmed that about 3544 nm (3.544 µm) of etching was done on the gallium arsenide surface.

### Example 68

### Step A: Pretreatment of substrate

The gallium arsenide substrate was washed with ultrapure water for 3 minutes, and treated with UV ozone for 10 minutes to remove an organic product on the substrate. The substrate was washed with ultrapure water for 3 minutes, and then treated for 1 minute with dilute hydrofluoric acid to remove an oxide film on the surface. Finally, the substrate was washed with ultrapure water for 10 minutes.

### Step B: Preparation and application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to the gallium arsenide substrate, which had been pre-treated and dried according to Step A.

### Step C: Temperature control of substrate

The gallium arsenide substrate obtained in Step B on which the organic compound having an N-F bond had been applied was placed on a hot plate with cooling function (trade name: Cool Plate, As One Corporation, type: SCP125), and the plate temperature was set at 28°C. The gallium arsenide substrate was left in a dark room for 240 minutes. The surface temperature was detected using a temperature sensor to confirm that the temperature during the experiment was as determined.

### Step E: Removal of a material containing an organic compound having an N-F bond

The material that contained the organic compound having an N-F bond on the surface of the gallium arsenide substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the gallium arsenide substrate obtained in Step E was measured using a phase-shift interference microscope (NewView, produced by Zygo Corporation). The results confirmed that about 1637 nm (1.637 µm) of etching was done on the gallium arsenide surface.

### Example 69

### Step A: Pretreatment of substrate

The gallium nitride substrate was washed with ultrapure water for 3 minutes, and treated with 97% sulfuric acid and 30% hydrogen peroxide water (sulfuric acid:hydrogen peroxide water = 4:1 (volume ratio)) for 10 minutes to remove an organic product on the substrate. The substrate was washed with ultrapure water for 10 minutes, and then treated for 10 minutes with 50% hydrofluoric acid to remove an oxide film on the surface. Finally, the substrate was washed with ultrapure water for 10 minutes.

### Step B: Preparation and application of an organic compound having an N-F bond

An organic compound having an N-F bond (I) and an organic compound having an N-F bond (II) were weighed out at 2:1 (mass ratio). The compounds were heated to 95°C for melting, and homogeneously mixed. After cooling, the mixture obtained was applied to the gallium nitride substrate, which had been pre-treated and dried according to Step A.

### Step C: Temperature control of substrate

The gallium nitride substrate obtained in Step B on which the organic compound having an N-F bond had been applied was placed on a hot plate with cooling function (trade name: Cool Plate, As One Corporation, type: SCP125), and the plate temperature was set at 28°C. The surface temperature was detected using a temperature sensor to confirm that the temperature during the experiment was as determined.

### Step D: Light irradiation

White light (exposure wavelength: 200 to 2000 nm, exposure intensity: 3.0 W/cm²) from the xenon lamp was applied for 30 minutes to the side of the organic compound having an N-F bond in the gallium nitride substrate whose surface temperature had been adjusted to 28°C in Step C.

### Step E: Removal of a material containing an organic compound having an N-F bond

The material that contained the organic compound having an N-F bond on the surface of the gallium nitride substrate was immersed in acetonitrile, and ultrasonic washing was performed for 20 seconds to remove the material containing the organic compound. Further, the remaining residue was immersed in acetone, and removed by 20 seconds of ultrasonic irradiation.

### Step F: Etching evaluation

The surface (etching depth) of the gallium nitride substrate obtained in Step E was measured using a phase-shift interference microscope (NewView, produced by Zygo Corporation). The results confirmed that about 8.5 nm of etching was done on the gallium nitride surface.

### Example 70

Example 70 was prepared in the same manner as Example 66, except that an indium phosphorus substrate was used in place of the germanium substrate. The surface (etching depth) of the resulting indium phosphorus substrate was measured using a phase-shift interference microscope (NewView, produced by Zygo Corporation). The results confirmed that about 1.2 nm of etching was done on the indium phosphorus surface.

### Example 71

Example 71 was prepared in the same manner as Example 1, except that the temperature was set at 125°C in Step C. Post-treatment similar to that in Example 1 was performed, and the surface (etching depth) of the resulting silicon substrate was measured using a phase-shift interference microscope. The results confirmed that about 5600 nm (5.6 µm) of etching was done on the silicon surface.

### Example 72

Example 72 was prepared in the same manner as Example 1, except that a silicon substrate (2) (2 cm x 2 cm) was used as a solid material, the temperature was set at 150°C in Step C, and white light was applied at an exposure intensity of 4.0 W/cm² using a xenon lamp for 1 minute in Step D. Post-treatment similar to that in Example 1 was performed.

The surface (etching depth) of the resulting silicon substrate was measured using a phase-shift interference microscope. The results confirmed that about 2.4 µm of etching was done on the silicon surface.

### Example 73

Example 73 was prepared in the same manner as Example 1, except that a silicon substrate (2) (2 cm x 2 cm) was used as a solid material, the temperature was set at 150°C in Step C, and white light was applied at an exposure intensity of 4.0 W/cm² using a xenon lamp for 5 minutes in Step D. Post-treatment similar to that in Example 1 was performed.

The surface (etching depth) of the resulting silicon substrate was measured using a phase-shift interference microscope. The results confirmed that about 7.8 µm of etching was done on the silicon surface.

### Example 74

Example 74 was prepared in the same manner as Example 1, except that a silicon substrate (2) (2 cm x 2 cm) was used as a solid material, the temperature was set at 150°C in Step C, and white light was applied at an exposure intensity of 4.0 W/cm² using a xenon lamp for 10 minutes in Step D. Post-treatment similar to that in Example 1 was performed.

The surface (etching depth) of the resulting silicon substrate was measured using a phase-shift interference microscope. The results confirmed that about 9.4 µm of etching was done on the silicon surface.

### Example 75

Example 75 was prepared in the same manner as Example 1, except that a silicon substrate (2) (2 cm x 2 cm) was used as a solid material, the temperature was set at 150°C in Step C, and white light was applied at an exposure intensity of 4.0 W/cm² using a xenon lamp for 15 minutes in Step D. Post-treatment similar to that in Example 1 was performed.

The surface (etching depth) of the resulting silicon substrate was measured using a phase-shift interference microscope. The results confirmed that about 10.2 µm of etching was done on the silicon surface.

The surface of the resulting silicon substrate was observed by a scanning electron microscope (SEM) (Fig. 1 (a4)). It was confirmed that pyramid-shaped convex portions having a size of about 3 µm were formed, and small inverted pyramid-shaped concave portions having a size of about 100 to 250 nm were formed on the entire surface of the substrate.

### Example 76

Example 76 was prepared in the same manner as Example 1, except that a silicon substrate (2) (2 cm x 2 cm) was used as a solid material, the temperature was set at 175°C in Step C, and white light was applied at an exposure intensity of 4.0 W/cm² using a xenon lamp for 1 minute in Step D. Post-treatment similar to that in Example 1 was performed.

The surface (etching depth) of the resulting silicon substrate was measured using a phase-shift interference microscope. The results confirmed that about 5.6 µm of etching was done on the silicon surface.

The surface of the resulting silicon substrate was observed by a scanning electron microscope (SEM) (Fig. 1 (b1)). It was confirmed that holes having a size of about 500 nm were formed.

### Example 77

Example 77 was prepared in the same manner as Example 1, except that a silicon substrate (2) (2 cm x 2 cm) was used as a solid material, the temperature was set at 175°C in Step C, and white light was applied at an exposure intensity of 4.0 W/cm² using a xenon lamp for 5 minutes in Step D. Post-treatment similar to that in Example 1 was performed.

The surface (etching depth) of the resulting silicon substrate was measured using a phase-shift interference microscope. The results confirmed that about 9.4 µm of etching was done on the silicon surface.

The surface of the resulting silicon substrate was observed by a scanning electron microscope (SEM) (Fig. 1 (b2)). It was confirmed that pyramid-shaped convex portions having a size of about 1 to 2 µm were formed, and small inverted pyramid-shaped concave portions having a size of about 100 to 200 µm were formed on the entire surface of the substrate.

### Example 78

Example 78 was prepared in the same manner as Example 1, except that a silicon substrate (2) (2 cm x 2 cm) was used as a solid material, the temperature was set at 175°C in Step C, and white light was applied at an exposure intensity of 4.0 W/cm² using a xenon lamp for 10 minutes in Step D. Post-treatment similar to that in Example 1 was performed.

The surface (etching depth) of the resulting silicon substrate was measured using a phase-shift interference microscope. The results confirmed that about 10.2 µm of etching was done on the silicon surface.

The surface of the resulting silicon substrate was observed by a scanning electron microscope (SEM) (Fig. 1 (b3)). It was confirmed that small inverted pyramid-shaped concave portions having a size of about 200 nm were formed on the entire surface of the substrate, and large pyramid-shaped convex portions were formed.

### Example 79

Example 79 was prepared in the same manner as Example 1, except that a silicon substrate (2) (2 cm x 2 cm) was used as a solid material, the temperature was set at 175°C in Step C, and white light was applied at an exposure intensity of 4.0 W/cm² using a xenon lamp for 15 minutes in Step D. Post-treatment similar to that in Example 1 was performed.

The surface (etching depth) of the resulting silicon substrate was measured using a phase-shift interference microscope. The results confirmed that about 9.4 µm of etching was done on the silicon surface.

The surface of the resulting silicon substrate was observed by a scanning electron microscope (SEM) (Fig. 1 (b4)). It was confirmed that small inverted pyramid-shaped concave portions having a size of about 50 to 250 nm were formed on the entire surface of the substrate, and large pyramid-shaped convex portions were formed.

### Example 80

Example 80 was prepared in the same manner as Example 37, except that a silicon substrate (2) (2 cm x 2 cm) was used as a solid material, the temperature was set at 175°C in Step C, and the substrate was left for 1 minute in a dark room. Post-treatment similar to that in Example 37 was performed.

The surface (etching depth) of the resulting silicon substrate was measured using a phase-shift interference microscope. The results confirmed that about 7.225 µm of etching was done on the silicon surface.

The surface of the resulting silicon substrate was observed by a scanning electron microscope (SEM) (Fig. 1 (c1)). It was confirmed that large pyramid-shaped convex portions having a size of about 1 to 6 µm were formed.

### Example 81

Example 81 was prepared in the same manner as Example 37, except that a silicon substrate (2) (2 cm x 2 cm) was used as a solid material, the temperature was set at 175°C in Step C, and the substrate was left for 5 minutes in a dark room. Post-treatment similar to that in Example 37 was performed.

The surface (etching depth) of the resulting silicon substrate was measured using a phase-shift interference microscope. The results confirmed that about 9.5 µm of etching was done on the silicon surface.

The surface of the resulting silicon substrate was observed by a scanning electron microscope (SEM) (Fig. 1 (c2)). Neither pyramid-shaped convex portions nor inverted pyramid-shaped concave portions were confirmed.

### Example 82

Example 82 was prepared in the same manner as Example 37, except that a silicon substrate (2) (2 cm x 2 cm) was used as a solid material, the temperature was set at 175°C in Step C, and the substrate was left for 10 minutes in a dark room. Post-treatment similar to that in Example 37 was performed.

The surface (etching depth) of the resulting silicon substrate was measured using a phase-shift interference microscope. The results confirmed that about 10.025 µm of etching was done on the silicon surface.

The surface of the resulting silicon substrate was observed by a scanning electron microscope (SEM) (Fig. 1 (c3)). It was confirmed that convexes and concaves were slightly formed on the surface.

### Example 83

Example 83 was prepared in the same manner as Example 37, except that a silicon substrate (2) (2 cm x 2 cm) was used as a solid material, the temperature was set at 175°C in Step C, and the substrate was left for 15 minutes in a dark room. Post-treatment similar to that in Example 37 was performed.

The surface (etching depth) of the resulting silicon substrate was measured using a phase-shift interference microscope. The results confirmed that about 10.725 µm of etching was done on the silicon surface.

The surface of the resulting silicon substrate was observed by a scanning electron microscope (SEM) (Fig. 1 (c4)). It was confirmed that small inverted pyramid-shaped concave portions having a size of about 25 nm were formed.

### Example 84

Example 84 was prepared in the same manner as Example 37, except that a silicon substrate (2) (2 cm x 2 cm) was used as a solid material, the temperature was set at 175°C in Step C, and the substrate was left for 30 minutes in a dark room. Post-treatment similar to that in Example 37 was performed.

The surface (etching depth) of the resulting silicon substrate was measured using a phase-shift interference microscope. The results confirmed that about 10.62 µm of etching was done on the silicon surface.

The surface of the resulting silicon substrate was observed by a scanning electron microscope (SEM) (Fig. 1 (c5)). It was confirmed that small inverted pyramid-shaped concave portions having a size of about 20 nm were formed.

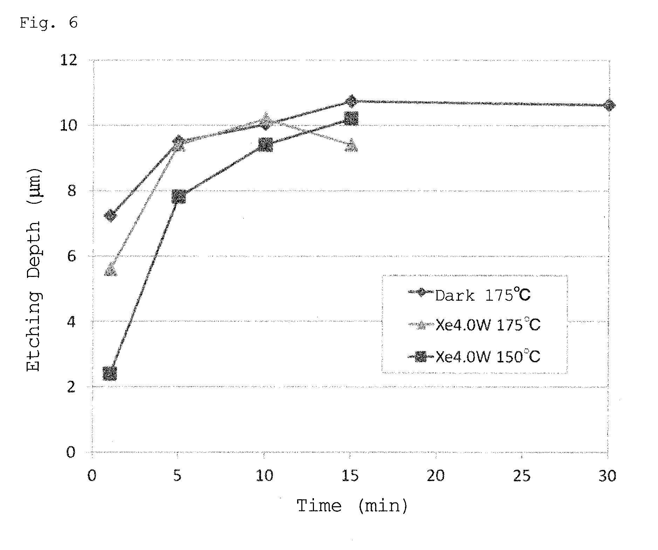

Fig. 6 shows the time under each temperature condition and etching depth in Examples 72 to 84.

Under the conditions (175°C, no light irradiation, 1 minute) in which the fastest etching speed was attained, the etching speed was 120 nm/s (7.2 µm/min), making it possible to perform etching at a speed remarkably faster than the conventional dry etching speed (6 nm/s; 11 µm/30 min). At a high temperature (175°C), no obvious difference in etching speed was observed between the presence and absence of light irradiation.

A difference in the shape of the surface after etching was observed between the presence and absence of light irradiation.

### Example 85

Example 85 was prepared in the same manner as Example 1, except that a silicon substrate (2) (2 cm x 2 cm) was used as a solid material, the temperature was set at 75°C in Step C, and white light was applied for 15 minutes at an exposure intensity of 4.0 W/cm² using a xenon lamp in Step D. Post-treatment similar to that in Example 1 was performed.

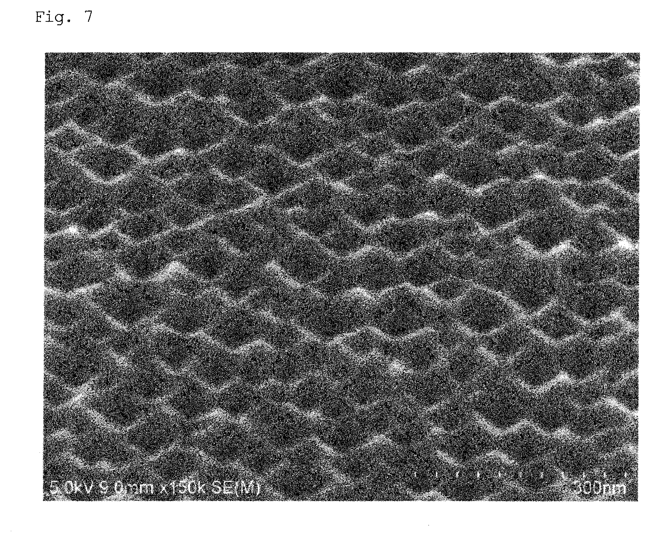

The surface of the resulting silicon substrate was observed by a scanning electron microscope (SEM) (Fig. 1 (c4)). It was confirmed that small inverted pyramid-shaped concave portions having a size of about 50 to 100 nm were formed on almost the entire surface of the substrate (Fig. 7).

### Example 86

Example 86 was prepared in the same manner as Example 1, except that a silicon substrate (2) (2 cm x 2 cm) was used as a solid material, the temperature was set at 100°C in Step C, and white light was applied for 15 minutes at an exposure intensity of 4.0 W/cm² using a xenon lamp in Step D. Post-treatment similar to that in Example 1 was performed.

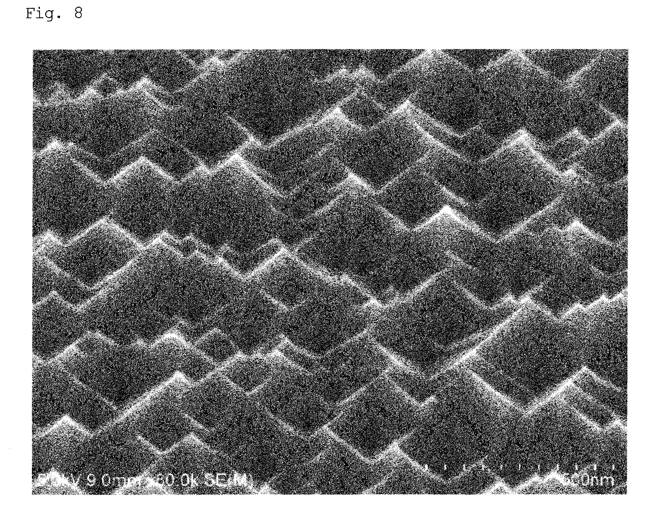

The surface of the resulting silicon substrate was observed by a scanning electron microscope (SEM). It was confirmed that small inverted pyramid-shaped concave portions having a size of about 100 to 200 nm were formed on almost the entire surface of the substrate (Fig. 8).

### Example 87

Example 87 was prepared in the same manner as Example 1, except that a silicon substrate (2) (2 cm x 2 cm) was used as a solid material, the temperature was set at 150°C in Step C, and irradiation was performed for 1 minute at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 5.6 µm of etching was done on the silicon surface.

The surface of the resulting silicon substrate was observed by a scanning electron microscope (SEM).

### Example 88

Example 88 was prepared in the same manner as Example 1, except that a silicon substrate (2) (2 cm x 2 cm) was used as a solid material, the temperature was set at 150°C in Step C, and irradiation was performed for 5 minutes at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 6.6 µm of etching was done on the silicon surface.

The surface of the resulting silicon substrate was observed by a scanning electron microscope (SEM).

### Example 89

Example 89 was prepared in the same manner as Example 1, except that a silicon substrate (2) (2 cm x 2 cm) was used as a solid material, the temperature was set at 150°C in Step C, and irradiation was performed for 10 minutes at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 7.1 µm of etching was done on the silicon surface.

The surface of the resulting silicon substrate was observed by a scanning electron microscope (SEM).

### Example 90

Example 90 was prepared in the same manner as Example 1, except that a silicon substrate (2) (2 cm x 2 cm) was used as a solid material, the temperature was set at 150°C in Step C, and irradiation was performed for 15 minutes at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 7.2 µm of etching was done on the silicon surface.

The surface of the resulting silicon substrate was observed by a scanning electron microscope (SEM).

### Example 91

Example 91 was prepared in the same manner as Example 1, except that a silicon substrate (2) (2 cm x 2 cm) was used as a solid material, the temperature was set at 150°C in Step C, and irradiation was performed for 30 minutes at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 8.5 µm of etching was done on the silicon surface.

The surface of the resulting silicon substrate was observed by a scanning electron microscope (SEM).

### Example 92

Example 92 was prepared in the same manner as Example 1, except that a silicon substrate (2) (2 cm x 2 cm) was used as a solid material, the temperature was set at 150°C in Step C, and irradiation was performed for 60 minutes at an irradiation intensity of 4.0 W/cm² using a halogen lamp in Step D. Post-treatment similar to that in Example 1 was performed, and the surface (etching depth) of the resulting silicon substrate was measured using a phase-shift interference microscope.

The results confirmed that about 9.0 µm of etching was done on the silicon surface.

The surface of the resulting silicon substrate was observed by a scanning electron microscope (SEM).

### Example 93

Example 93 was prepared in the same manner as Example 1, except that a silicon substrate (2) (2 cm x 2 cm) was used as a solid material, the temperature was set at 150°C in Step C, and irradiation was performed for 1 minute at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 5.3 µm of etching was done on the silicon surface.

The surface of the resulting silicon substrate was observed by a scanning electron microscope (SEM).

### Example 94

Example 94 was prepared in the same manner as Example 1, except that a silicon substrate (2) (2 cm x 2 cm) was used as a solid material, the temperature was set at 150°C in Step C, and irradiation was performed for 5 minutes at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 7.5 µm of etching was done on the silicon surface.

The surface of the resulting silicon substrate was observed by a scanning electron microscope (SEM).

### Example 95

Example 95 was prepared in the same manner as Example 1, except that a silicon substrate (2) (2 cm x 2 cm) was used as a solid material, the temperature was set at 150°C in Step C, and irradiation was performed for 10 minutes at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 8.0 µm of etching was done on the silicon surface.

The surface of the resulting silicon substrate was observed by a scanning electron microscope (SEM).

### Example 96

Example 96 was prepared in the same manner as Example 1, except that a silicon substrate (2) (2 cm x 2 cm) was used as a solid material, the temperature was set at 150°C in Step C, and irradiation was performed for 15 minutes at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 8.8 µm of etching was done on the silicon surface.

The surface of the resulting silicon substrate was observed by a scanning electron microscope (SEM).

### Example 97

Example 97 was prepared in the same manner as Example 1, except that a silicon substrate (2) (2 cm x 2 cm) was used as a solid material, the temperature was set at 150°C in Step C, and irradiation was performed for 30 minutes at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 9.1 µm of etching was done on the silicon surface.

The surface of the resulting silicon substrate was observed by a scanning electron microscope (SEM).

### Example 98

Example 98 was prepared in the same manner as Example 1, except that a silicon substrate (2) (2 cm x 2 cm) was used as a solid material, the temperature was set at 150°C in Step C, and irradiation was performed for 60 minutes at an irradiation intensity of 7.0 W/cm² using a halogen lamp in Step D. Post-treatment similar to that in Example 1 was performed, and the surface (etching depth) of the resulting silicon substrate was measured using a phase-shift interference microscope.

The results confirmed that about 9.3 µm of etching was done on the silicon surface.

The surface of the resulting silicon substrate was observed by a scanning electron microscope (SEM).

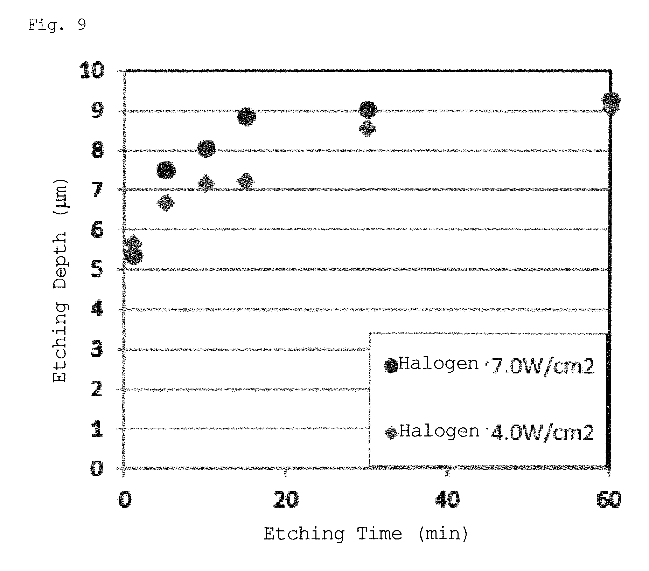

Fig. 9 shows the relationship between the irradiation intensity, and the etching time and etching depth in Examples 87 to 98.

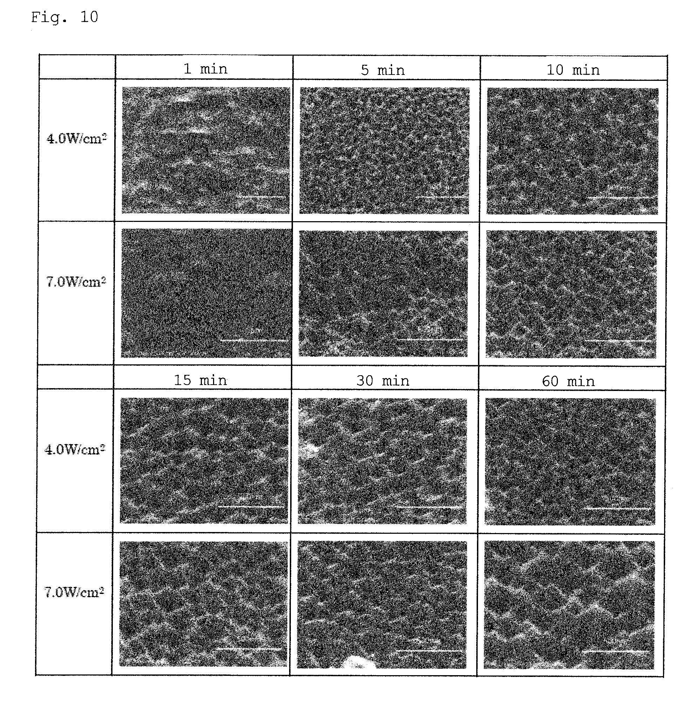

Fig. 10 shows the SEM observation results of the obtained silicon substrate surface conditions. It was found that an inverted pyramid surface shape began to form about five minutes after the initiation of irradiation, regardless of the intensity of irradiation. On the other hand, there was a tendency for the size of the holes of the inverted pyramid shape on the surface to rapidly increase as the irradiation intensity became high. This is presumably because the etching speed is proportional to the irradiation intensity.

## Claims

1. A method for etching a solid material comprising the steps of:
(1) bringing a material containing at least one organic compound having an N-F bond into contact with a surface of a solid material; and
(2) heating the solid material.

2. The etching method according to Claim 1, wherein the solid material is heated to 28°C or higher in step (2).

3. The etching method according to Claim 1 or 2, wherein the solid material is heated to 60°C or higher in step (2).

4. The etching method according to Claim 1 or 2, further comprising step (3) of:
exposing the solid material to light from a side of the material containing at least one organic compound having an N-F bond.

5. The etching method according to Claim 3, further comprising step (3) of:
exposing the solid material to light from a side of the material containing at least one organic compound having an N-F bond.

6. The etching method according to any one of Claims 1 to 5, wherein the organic compound having an N-F bond has a structural unit represented by Formula (1) below. 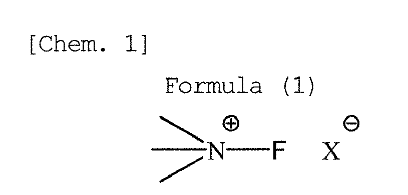 wherein
[Chem. 2] X^{Θ}
represents a conjugate base of a Bronsted acid.

7. The etching method according to any one of Claims 1 to 6, wherein the organic compound having an N-F bond is a compound represented by Formula (A1). 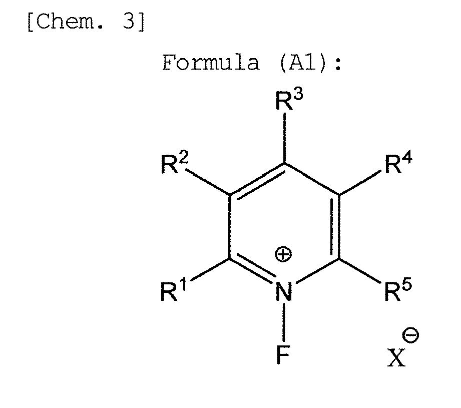
wherein two adjacent R¹ and R², R² and R³, R³ and R⁴, or R⁴ and R⁵ may connect to each other to form -CR⁶=CR⁷-CR⁸=CR⁹-,
R¹, R², R³, R⁴, R⁵, R⁶, R⁷, R⁸ and R⁹ may be the same or different, and each may be individually a hydrogen atom; halogen atom; nitro group; hydroxy group; cyano group; carbamoyl group; a C₁₋₁₅ alkyl group optionally substituted with at least one member selected from the group consisting of halogen atoms, hydroxy group, C₁₋₅ alkoxy groups, C₆₋₁₀ aryloxy groups, C₁₋₅ acyl groups, C₁₋₅ acyloxy groups and C₆₋₁₀ aryl groups; a C₁₋₁₅ alkenyl group optionally substituted with at least one member selected from the group consisting of halogen atoms and C₆₋₁₀ aryl groups; a C₁₋₁₅ alkynyl group optionally substituted with at least one member selected from the group consisting of halogen atoms and C₆₋₁₀ aryl groups; a C₆₋₁₅ aryl group optionally substituted with at least one member selected from the group consisting of halogen atoms and C₁₋₅ alkyl groups; a C₁₋₁₅ acyl group optionally substituted with at least one halogen atom; a C₂₋₁₅ alkoxycarbonyl group optionally substituted with at least one member selected from the group consisting of halogen atoms and C₆₋₁₀ aryl groups; a C₇₋₁₅ aryloxycarbonyl group optionally substituted with at least one member selected from the group consisting of halogen atoms and C₁₅ alkyl groups; a C₁₋₁₅ alkylsulfonyl group optionally substituted with at least one member selected from the group consisting of halogen atoms and C₆₋₁₀ aryl groups; a C₆₋₁₅ arylsulfonyl group optionally substituted with at least one member selected from the group consisting of halogen atoms and C₁₋₅ alkyl groups; a C₁₋₁₅ alkylsulfinyl group optionally substituted with at least one member selected from the group consisting of halogen atoms and C₆₁₀ aryl groups; a C₆₋₁₅ arylsulfinyl group optionally substituted with at least one member selected from the group consisting of halogen atoms and C₁₋₅ alkyl groups; a C₁₋₁₅ alkoxy group optionally substituted with at least one member selected from the group consisting of halogen atoms and C₆₋₁₀ aryl groups; a C₆₋₁₅ aryloxy group optionally substituted with at least one member selected from the group consisting of halogen atoms and C₁₋₅ alkyl groups; a C₁₋₁₅ acyloxy group optionally substituted with at least one halogen atom; a C₁₋₁₅ acylthio group optionally substituted with at least one halogen atom; a C₁₋₁₅ alkanesulfonyloxy group optionally substituted with at least one member selected from the group consisting of halogen atoms and C₆₋₁₀ aryl groups; a C₆₋₁₅ arylsulfonyloxy group optionally substituted with at least one member selected from the group consisting of halogen atoms and C₁₋₅ alkyl groups; a carbamoyl group optionally substituted with at least one member selected from the group consisting of C₁₋₅ alkyl groups and C₆₋₁₀ aryl groups; an amino group optionally substituted with at least one member selected from the group consisting of C₁₋₅ acyl groups and halogen atoms; a C₆₋₁₅ N-alkylpyridinium base optionally substituted with at least one member selected from the group consisting of halogen atoms, C₆₋₁₀ aryl groups and C₁₋₅ alkyl groups; a C₁₁₋₁₅ N-arylpyridinium base optionally substituted with at least one member selected from the group consisting of halogen atoms, C₆₋₁₀ aryl groups and C₁₋₅ alkyl groups; or an organic polymer chain,
wherein R¹, R², R³, R⁴, R⁵, R⁶, R⁷, R⁸ and R⁹ may form a ring structure in various combinations with or without having a hetero atom therebetween,
wherein
[Chem. 4] X^{Θ}
represents a conjugate base of a Bronsted acid.

8. The etching method according to any one of Claims 1 to 7, wherein the solid material is a semiconductor or an insulator.

9. The etching method according to any one of Claims 1 to 8, wherein the solid material is at least one member selected from the group consisting of silicon, germanium, silicon germanium, silicon carbide, gallium arsenide, gallium aluminum arsenide, indium phosphide, indium antimonide, gallium nitride and aluminium nitride.

10. A method for applying light-trapping and/or anti-reflection processing to a surface of a solid material for a solar cell, wherein the application method employs the etching method of any one of Claims 1 to 9.

11. A method for producing an etched article comprising the steps of:
(1) bringing a material containing at least one organic compound having an N-F bond into contact with a surface of a solid material; and
(2) heating the solid material.

12. The method according to Claim 11, further comprising:
(3) exposing the solid material to light from a side of the material containing at least one organic compound having an N-F bond.

13. An etched article produced by the method of Claim 11 or 12.

14. A silicon solar cell comprising an etched article obtained by subjecting a solid material to an etching process according to the method of Claim 11 or 12, and the solid material is silicon.
